# EUROPEAN PATENT APPLICATION

(11) **EP 2 816 622 A1**
(43) Date of publication of application: **24.12.2014**
(21) Application number: 13748488.7
(22) Date of filing: 14.02.2013
(51) Int. Cl.: H01L 33/64, H01L 33/62

(54) **LIGHT EMITTING APPARATUS AND METHOD FOR MANUFACTURING SAME**

(30) Priority: 15.02.2012 JP 2012030741
(71) Applicant: Panasonic Corporation, Kadoma-shi, Osaka 571-8501 (JP)
(72) Inventor: KAWAKITA, Koji, Osaka-shi, Osaka 540-6207 (JP); NAKATANI, Seiichi, Osaka-shi, Osaka 540-6207 (JP); OGAWA, Tatsuo, Osaka-shi, Osaka 540-6207 (JP); SAWADA, Susumu, Osaka-shi, Osaka 540-6207 (JP)
(74) Representative: Eisenführ Speiser
(86) International application number: PCT/JP2013/000818
(87) International publication number: WO 2013/121787

(57) **Abstract**

There is provided a light-emitting device comprising a light-emitting element and a substrate for light-emitting element. The light-emitting element is in a mounted state on a mounting surface of the substrate, the mounting surface being one of two opposed main surfaces of the substrate. The substrate is provided with a protection element for the light-emitting element, the protection element comprising a voltage-dependent resistive layer embedded in the substrate, and comprising a first electrode and a second electrode each of which is in connection with the voltage-dependent resistive layer. The mounted light-emitting element is in an overlapping relation with the voltage-dependent resistive layer. A reflective layer is provided on at least one of the substrate and the voltage-dependent resistive layer such that the reflective layer is located adjacent to the first electrode which is in contact with a substrate exposure surface of the voltage-dependent resistive layer.

## Description

### TECHNICAL FIELD

The present invention relates to a light-emitting device and a method for manufacturing the light-emitting device. More particularly, the present invention relates to a light-emitting device with a mounted light-emitting element, and a method for manufacturing such device.

### BACKGROUND OF THE INVENTION

Recently, LEDs serving as a light source are used for various purposes in terms of their longer life and energy saving. Especially during recent years, luminous efficiency of the LEDs for the high-light use is improving and thus the LEDs are becoming to be used for a lighting purpose.

In a case of a white LED used for the lighting purpose, the light quantity can be increased by applying a larger current to the LED. However, a performance of the LED can be degraded under such a severe condition that the large current is applied. Therefore, it is concerned that the LED package and a LED module cannot have a longer life and a high reliability. For example, when an electric current flowing through the LED is increased, the heat attributed to the LED increases. Accordingly, the temperature tends to rise in the LED module for lighting and a system thereof, which can cause a deterioration of the LED module and the system. In this regard, only about 25% of the electric power to be consumed in the white LED is converted into the visible light and the rest of the electric power is directly converted into the heat. Therefore, it is required to release the heat from the LED package and the LED module. For example, various types of heat sinks are used to release the heat, wherein the heat sink may be mounted to a bottom surface of a package substrate in order to improve the heat release.

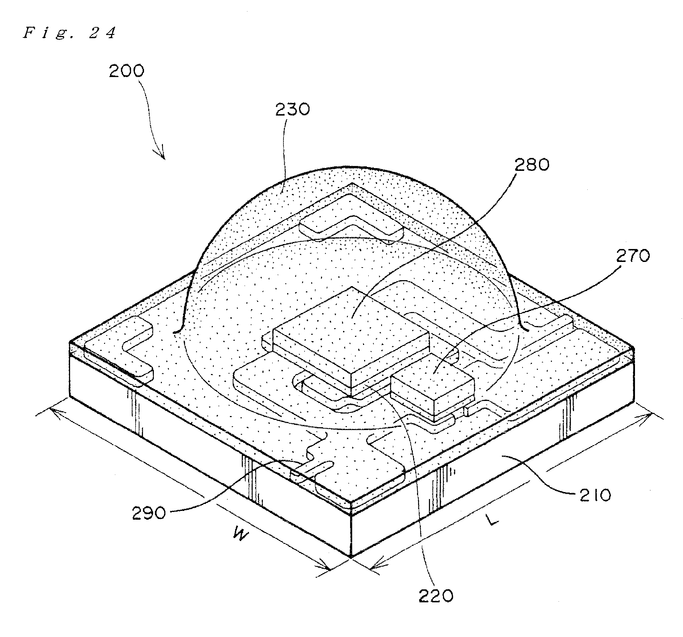

In general, the LED does not have a high resistance property against a static electricity, and thus the designs or measures for protecting the LED from such stress attributed to the static electricity may be employed (see, Patent Literature 1). For example, a Zener diode may be provided in electrically parallel connection with the LED. This can reduce the stress of the LED upon the applying of the overvoltage or overcurrent to the LED. However, in a case of a surface-mounted type LED package 200 as illustrated in Fig. 24, the Zener diode element 270 is disposed on a package substrate 210 such that it is in reversely parallel connection with the LDE element 220. The disposition of the Zener diode element 270 on the substrate makes the size of the entire package larger. That is, a further downsizing of the LED package cannot be achieved.

Moreover, the recent LED requires not only its downsizing but also an improvement of light use efficiency. That is, higher brightness of the LED is required.

### PATENT DOCUMENTS (PRIOR ART PATENT DOCUMENTS)

PATENT DOCUMENT 1: JP-A-2009-129928

### DISCLOSURE OF THE INVENTION

### PROBLEMS TO BE SOLVED BY THE INVENTION

The present invention has been created in view of the above circumstances. In other words, in light of a need for a compact LED package with a satisfactory heat-releasing performance and brightness, an object of the present invention is to provide a light-emitting device which suitably satisfies the above need, and also provide a method for such device.

### MEANS FOR SOLVING THE PROBLEM

In order to achieve the above object, the present invention provides a light-emitting device comprising a light-emitting element and a substrate for light-emitting element,
wherein the light-emitting element is in a mounted state on a mounting surface of the substrate, the mounting surface being one of two opposed main surfaces of the substrate,
wherein the substrate is provided with a protection element for the light-emitting element, the protection element comprising a voltage-dependent resistive layer embedded in the substrate, and also comprising a first electrode and a second electrode each of which is in connection with the voltage-dependent resistive layer,
wherein the mounted light-emitting element is in an overlapping relation with the voltage-dependent resistive layer, and
wherein a reflective layer is provided on at least one of the substrate and the voltage-dependent resistive layer such that the reflective layer is located adjacent to the first electrode which is in contact with a substrate exposure surface of the voltage-dependent resistive layer.

In the light emitting device of the present invention, not only the voltage-dependent resistive layer of the protection element is in an embedded state within the substrate to be positioned in the overlapping relation with the light-emitting element, but also the reflective layer is provided on at least one of the substrate and the voltage-dependent resistive layer to be located adjacent to the first electrode which is in contact with the substrate exposure surface of the voltage-dependent resistive layer. In other words, one of the features regarding the light emitting device is that not only the voltage-dependent resistive layer of the protection element is embedded in the mounting area for the light-emitting element, but also the reflective layer is positioned in a particular region adjacent to the electrode of the protection element, the electrode being on the mounting surface of the substrate for light-emitting element.

The term *"light-emitting element"* used in the present description substantially means an element capable of emitting light. Examples of the light-emitting element include a light-emitting diode (LED) and an electronic component equipped therewith. Accordingly, the term *"light-emitting element"* in the present invention means not only a "bare chip type LED (i.e., LED chip)" but also a "discrete type light-emitting element wherein a molding of the LED chip is provided for an easy packaging thereof with respect to the substrate". The LED chip may also be a semiconductor laser chip.

The term *"light-emitting device"* used in the present description substantially means a light-emitting element package (especially "LED package"). This term (i.e., *"light-emitting device")* also means "product with a plurality of LEDs arranged in a form of array". In a case where the light-emitting element is a LED chip equipped with a positive electrode and a negative electrode on its surface which is opposed to a light-emitting surface of the LED chip, the LED chip may be in a mounted state on the mounting surface of the substrate in a manner of flip-chip.

The term *"voltage-dependent resistive layer"* used in the present description substantially means a layer capable of changing its resistive property according to a voltage to be applied thereto. The voltage-dependent resistive layer may be one in which the high electrical resistance is provided in the range of the low voltage applied across the electrodes disposed on both sides thereof, whereas the electrical resistances sharply drops if the higher voltage is applied. This means that the voltage-dependent resistive layer can have a nonlinearity relationship between the applied voltage and the resistance value. In an embodiment according to the present invention, the voltage-dependent resistive layer may be in the form of "single layer".

The term *"substrate"* used in the present description substantially means a member to be used as a platform for mounting the light-emitting element. Therefore, the examples of the substrate for light-emitting element include not only a "plate member having a substantially flat form" but also a "member having a recessed portion in its main surface to accommodate the LED chip and the like therein".

Furthermore, the present invention also provides a method for manufacturing the above-described device. More specifically, the present invention provides the method for manufacturing the light-emitting device comprising a substrate for light-emitting element and a light-emitting element mounted on the substrate, the substrate including a varistor element comprising a voltage-dependent resistive layer embedded in the substrate and first and second electrodes each of which is in connection with the voltage-dependent resistive layer, the method comprising the steps of:
(A) forming a second electrode precursor layer on a main surface of a green sheet;
(B) pressing the second electrode precursor layer into the green sheet from above by means of a convex-shaped die, and thereby forming a recessed portion in the green sheet with the second electrode precursor layer disposed on a bottom surface of the recessed portion;
(C) disposing the voltage-dependent resistive layer in the recessed portion;
(D) sintering the green sheet with the voltage-dependent resistive layer and the second electrode precursor layer disposed in the recessed portion of the green sheet, and thereby producing a substrate with the voltage-dependent resistive layer and the second electrode embedded in the substrate;
(E) forming a reflective layer on the substrate and/or the voltage-dependent resistive layer; and
(F) forming the first electrode on the substrate except for a forming region for the reflective layer, the first electrode being in contact with the voltage-dependent resistive layer.

The manufacturing method according to the present invention is characterized at least in that the reflective layer is formed on the substrate and/or the voltage-dependent resistive layer, and that the first electrode is formed on the substrate except for a forming region for the reflective layer to bring the first electrode into contact with the voltage-dependent resistive layer. One of other features regarding the method is that the substrate for light-emitting element is prepared by the voltage-dependent resistive layer which has been beforehand formed, and then the light-emitting device is manufactured by the use of such substrate.

### EFFECT OF THE INVENTION

### (Improved Utilization Efficiency of Light)

In the light emitting device of the present invention, a light reflection efficiency can be additionally improved because the reflective layer is located beneath the light-emitting element such that they are adjacent to each other. Specifically, the downward light emitted from the light-emitting diode can be reflected by the reflective layer, and thus such emitted light can be utilized without a substantial loss. In particular, the reflective layer can not only contribute to an improvement of the luminous efficiency, but also serve to protect the voltage-dependent resistive layer *("protection function of voltage-dependent resistive layer"* will be described below). The light-emitting device of the present invention makes it possible to suitably downsize the device due to the voltage-dependent resistive layer embedded in the substrate. This makes it possible to realize a LED product having a higher luminous efficiency and a higher brightness while having its smaller size *("smaller size"* and *"higher brightness"* will be described below).

### (Protection Function of Reflective and Protective Layer)

In accordance with the present invention, the reflective layer can be used as a protective layer with respect to the voltage-dependent resistive layer. For example, the reflective layer can be used for protecting the voltage-dependent resistive layer from its damage occurred during the formation of the electrode of the protection element. By way of example, in a case where a foundation layer is formed on the substrate by a sputtering process, and then the first electrode is formed thereon by a plating process, the reflective layer can be used for protecting the voltage-dependent resistive layer from a reagent used for such processes, e.g., acid, alkari or plating reagent. Such usage of the reflective layer makes it possible to keep the initial properties of the voltage-dependent resistive layer due to the fact that the voltage-dependent resistive layer is not impaired. This can ensure that the device has a desired performance of the protection element (i.e., varistor element), which leads to an achievement of the desired LED product its higher quality (i.e., higher reliability of the protection element).

### (Compact Sizing and Improved Heat Releasing)

The light-emitting device according to the present invention is configured such that the voltage-dependent resistive layer of the protective element is embedded in an overlapping relation with the mounting surface for the light-emitting element to be mounted. This leads to an achievement of a compact-sizing of the device as a whole. Accordingly, the light-emitting device of the present invention is suitable as the packaging device in various purposes (e.g., in the lighting use), and it can effectively contribute to the down-sizing of an end product.

Further, the light-emitting device according to the present invention has such a configuration that the protection element (especially, voltage-dependent resistive layer and one of the electrodes, occupying a larger volume in the protection element) is substantially eliminated from the surface of the substrate. This makes it possible to save a space for the other components disposed on the surface of the substrate. For example, there can be formed the spaces for the electrodes and metal patterns to be provided on the mounting surface of the substrate for light-emitting element. The electrodes and the metal patterns are connected with the light-emitting element which generates the heat, and they are made of a material with a high thermal conductivity (e.g., copper), which effectively contributes to the heat releasing from the light-emitting element product. In accordance with the present invention, the space formed due to the "embedding" of the protection element can contribute to larger size and thicker dimension of the electrodes and the metal patterns capable of releasing the heat, and thereby the heat-releasing performance can be effectively improved in the light-emitting element product.

Particularly in a case where the reflective layer is made of resin component so that it has insulating properties, an electrical short can be effectively prevented. This makes it possible to narrow the distance between the divided two pieces of the first electrode, which leads to an achievement of an enlarged first electrode while the substrate is not enlarged. This means that the reflective layer can indirectly contribute to an improvement of the heat releasing performance of the device.

Moreover, in accordance with the present invention, the substrate with satisfactory heat-resisting and heat-releasing properties can be used (for example, ceramic substrate can be used) as the light-emitting element substrate with the voltage-dependent resistive layer embedded therein. This also makes it possible to improve the heat-releasing performance of the device.

The light-emitting device according to the present invention is configured such that the protection element is embedded without increasing of the thickness of the substrate. The reason for this is that, under the condition of the embedding of the protection element (more specifically, the voltage-dependent resistive layer and the one of the electrodes of the varistor element) in the substrate, the voltage-dependent resistive layer can be in a form of a single layer. Therefore, a thinning of the light-emitting element substrate with the protection element accommodated therein is achieved, and thereby the heat from the light-emitting element can be released to the outside, which leads to an improvement of the heat releasing performance in the light-emitting element product.

In general, the luminous efficiency (i.e., a ratio of the driving current being converted into the light) of the light-emitting element (especially, the LED) tends to be decreased with increased temperature, and thus the brightness of the light-emitting element becomes lowered when the temperature rises. In this regard, according to the present invention, the substrate with the improved luminous efficiency and brightness can be provided since it has an excellent performance of the heat releasing. Moreover, the device according to the present invention has such an excellent heat releasing performance that an operation life of the LED can be prolonged and also the degradation and/or color change of a sealing resin, which may be attributed to the heat, can be effectively prevented.

### BRIEF DESCRIPTION OF THE DRAWINGS

Fig. 1 includes a perspective view and a cross-sectional view schematically illustrating a light-emitting device according to the present invention.
Fig. 2 is a cross-sectional view schematically illustrating a light-emitting device according to the present invention.
Fig. 3 is a circuit diagram with respect to a light-emitting element and a protection element.
Fig. 4 is a perspective view schematically illustrating a light-emitting device in a form of LED package according to the present invention.
Fig. 5 is a cross-sectional view schematically illustrating a light-emitting device (i.e., LED package) according to an embodiment "Substrate back face-embedment of voltage-dependent resistive layer".
Fig. 6 is a cross-sectional view schematically illustrating a light-emitting device (i.e., LED package) according to an embodiment "Through-electrode".
Figs. 7A to 7C are cross sectional views schematically illustrating a light-emitting device (i.e., LED package) according to an embodiment "Disposition in recessed-portion".
Figs. 8A and 8B are cross sectional views schematically illustrating a light-emitting device (i.e., LED package) according to an embodiment "Built-in multilayer varistor".
Fig. 9 is a cross sectional view schematically illustrating an embodiment "Embedding of second electrode in the interior of voltage-dependent resistive layer".
Fig. 10 includes cross sectional views schematically illustrating an embodiment "Heterogeneous ceramic substrate".
Figs. 11A to 11G are process-cross sectional views schematically illustrating a manufacturing method of a substrate for a light-emitting device according to the present invention.
Figs. 12A to 12G are process-cross sectional views schematically illustrating a manufacturing method of a substrate for a light-emitting device according to the present invention.
Figs. 13A and 13B are process-cross sectional views schematically illustrating a manufacturing method of a substrate for a light-emitting device according to the present invention.
Figs. 14A to 14F are process-cross sectional views schematically illustrating a semi-additive process.
Figs. 15A to 15D are cross-sectional views illustrating the steps in a manufacturing process of a carrier film with the voltage-dependent resistive layers provided thereon.
Figs. 16A to 16F are cross-sectional views illustrating the steps in a manufacturing process with respect to an embodiment "Direct pressing 1".
Figs. 17A to 17F are cross-sectional views illustrating the steps in a manufacturing process with respect to an embodiment "Direct pressing 2".
Figs. 18A to 18D are cross-sectional views illustrating the steps in a manufacturing process of a carrier film with the voltage-dependent resistive layers and the second electrode precursor layers provided thereon.
Figs. 19A to 19F are cross-sectional views illustrating the steps in a manufacturing process with respect to an embodiment "Disposition in recessed-portion".
Figs. 20A and 20B are cross-sectional views illustrating the steps in a manufacturing process with respect to an embodiment "Sintered substrate with recessed-portion".
Figs. 21A and 21B are cross-sectional views illustrating the steps in a manufacturing process with respect to an embodiment "Use of electrode-accommodated resistive layer".
Fig. 22 includes schematic illustrations showing a process for producing a substrate with a plurality of protection elements disposed in a form of array.
Fig. 23 includes schematic illustrations showing an example of an LED product according to the present invention.
Fig. 24 is a perspective view schematically illustrating a construction of the conventional LED package (PRIOR ART).

### DETAILED DESCRIPTION OF THE INVENTION

A light-emitting device according to the present invention will be hereinafter described in more detail. It should be noted that various components or elements are schematically shown in the drawings wherein their dimensional proportions and their appearances are not necessarily real ones, and are merely for the purpose of making it easy to understand the present invention.

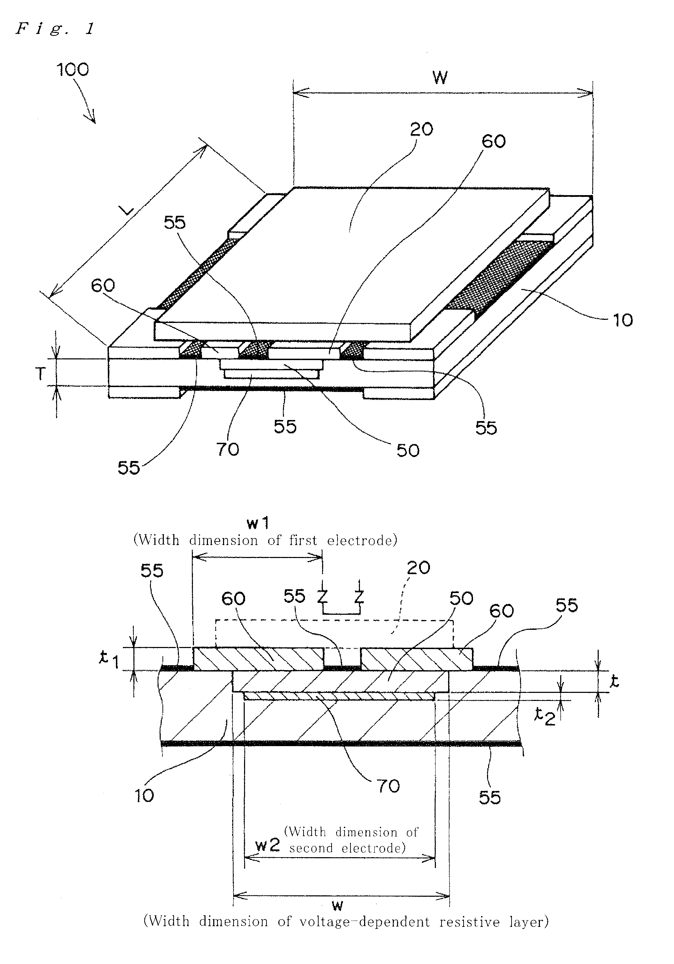

As shown in Fig. 1, the light-emitting device 100 of the present invention comprises "substrate 10 for light-emitting element" and "light-emitting element 20". As shown in Fig. 1, on a mounting surface which is one of two opposed main surfaces of the substrate 10, the light-emitting element 20 is in a mounted state.

In the substrate 10 for light-emitting element, a voltage-dependent resistive layer 50 of a protection element is in an embedded state in a substrate region in an overlapping relation with the light-emitting element. More specifically, as illustrated in Fig. 1, the voltage-dependent resistive layer 50 of the protection element is in an embedded state at the mounting area for the light-emitting element within the substrate 100. In the present invention, the voltage-dependent resistive layer 50 is in an embedded state such that it at least partially overlaps the light-emitting element 20. Thus, in some cases, only a part of the voltage-dependent resistive layer 50 may be overlapped with the light-emitting element 20.

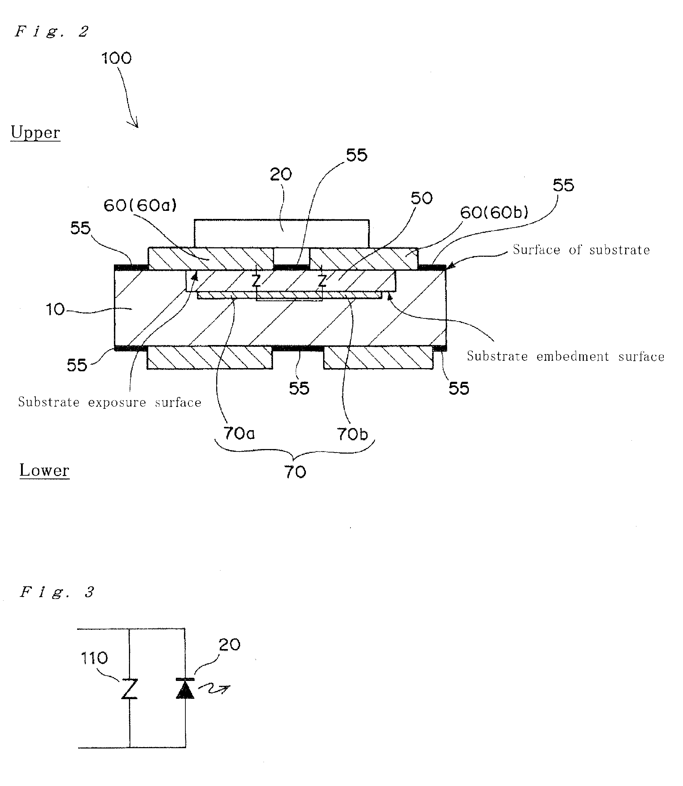

As shown in Fig. 2, "first electrode 60 of the protection element" is positioned on the exposed surface (i.e., substrate exposure surface) of the voltage-dependent resistive layer 50 such that the first electrode 60 is in an electrical connection with the voltage-dependent resistive layer 50. While on the other hand, "second electrode 70 of the protection element" is positioned on a substrate embedment surface of the voltage-dependent resistive layer 50 in an opposed relation to the first electrode 60 such that the second electrode 70 is in an electrical connection with the voltage-dependent resistive layer 50. The phrase *"substrate exposure surface of the voltage-dependent resistive layer"* used in the present description means an exposed surface of the voltage-dependent resistive layer, the exposed surface being exposed at the surface of the substrate. More specifically, supposing that only the substrate 10 for light-emitting element is extracted from the device, *"substrate exposure surface of the voltage-dependent resistive layer"* corresponds to an exposed surface of the voltage-dependent resistive layer, which has been exposed at the surface of the substrate so that the exposed surface is flush with the surface of the substrate. While on the other hand, the phrase *"substrate embedment surface of the voltage-dependent resistive layer"* used in the present description means a one surface of the voltage-dependent resistive layer, the one surface being located at the internal region of the substrate.

The first and second electrodes 60, 70 of the protection element substantially serve as external electrodes of the protection element, and thus they can contribute to a parallel electrical connection between the protection element and the light-emitting element. In order to allow the parallel electrical connection between the protection element and the light-emitting element to provide a protective function, the first electrode and the second electrode are directly connected to the electrodes of the light-emitting element, respectively, or are electrically connected to wiring patterns (i.e., patterned metal layers) disposed in the substrate. In other words, the first electrode and the second electrode of the protection element, as required, may be in an electrical connection with the wiring patterns (i.e., patterned metal layers) and the like of the substrate to form a typical circuit diagram as illustrated in Fig. 3.

As shown in Figs 1. and 2, at least one reflective layer 55 is provided on the substrate 10 (more specifically, the body of the substrate) and/or the voltage-dependent resistive layer 50. The reflective layer 55 is located adjacent to the first electrode 60 which is in contact with the substrate exposure surface of the voltage-dependent resistive layer 50. As shown in Figs 1. and 2, it is preferred that the side face of the reflective layer 55 (especially, the side face of the reflective layer 55 adjacent to the first electrode 60) is in a close contact with the side face of the first electrode 60. That is, it is preferred that the side face of the reflective layer 55 and the side face of the first electrode 60 are in contact with each other. The reflective layer 55 is preferably made of an insulating material having light-reflecting properties. For example, the material of the reflective layer may be resin or glass component which contains an oxide ceramic component therein. Examples of the resin component include at least one of metal materials selected from the group consisting of epoxy resin, polyimide resin, acrylic resin, polyethylene terephthalate resin, polyethylene naphthalate resin, polyethylene naphthalate resin, liquid crystal polymer and polyethylene naphthalate. The glass component may be one made from a glass raw material such as SiO₂, B₂O₃ and combination thereof. The oxide ceramic component may be titanium oxide and/or alumina. In a case where the heat releasing property and LED operation reliability are highly desired, the reflective layer is preferably made of combination of the glass component and the oxide ceramic component.

The reflective layer 55 serves as a protective layer for protecting the voltage-dependent resistive layer 50. This means that the reflective layer 55 not only serves to reflect the light from the light-emitting element 20, but also preferably serves to protect the voltage-dependent resistive layer 50. More specifically, the reflective layer 55 is used for protecting the voltage-dependent resistive layer from the outside during the formation of the first electrode. The reflective layer can be used for protecting the voltage-dependent resistive layer from a reagent (e.g., acid, alkali, plating reagent or combination thereof) used for the formation of the first electrode wherein a foundation layer is formed on the substrate by a sputtering process and then the first electrode is formed thereon by a plating process. Such usage of the reflective layer makes it possible to keep the initial properties of the voltage-dependent resistive layer due to the fact that the voltage-dependent resistive layer is not impaired by the reagent. This can ensure that the device has a desired performance of the protection element (i.e., varistor element).

The thickness of the reflective layer 55, which may depend on the kinds of the material to be used, is preferably in the approximate range of 1 um to 20 um. When the reflective layer has the thickness of more than 20 um, the device may have the insufficient reflectivity. On the other hand, when the reflective layer has the thickness of less than 20 um, the device may have the insufficient function of protecting the voltage-dependent resistive layer. It is more preferred that the thickness of the reflective layer 55 may be in the approximate range of 5 um to 15 um.

Since the reflective layer preferably has the insulating properties, the distance between the divided two pieces of the first electrode can be narrowed. In other words, in a case where the reflective layer serves as a insulating layer made of the resin component, the electrical short can be more effectively prevented, which makes it possible to narrow the distance between the divided two pieces of the first electrode. More specifically, it is possible to narrow the distance between the first sub-electrode 60a and first sub-electrode 60b (see Fig. 2). This enables the size of the first electrode to be larger while keeping the same size of the substrate, which leads to an achievement of the improved heat releasing properties without the larger size of the device. The reflective layer, which is located between the divided two pieces of the first electrode on the substrate exposure surface of the voltage-dependent resistive layer, can have a narrowed width dimension of 20 µm to 100 µm, preferably 20 µm to 60 µm, more preferably 20 µm to 40 µm.

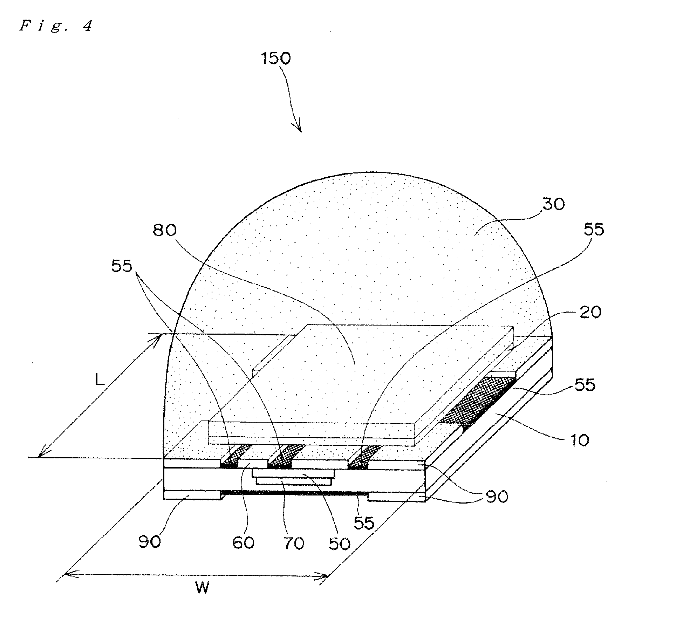

The light-emitting device of the present invention can be practically provided as a LED package 150 as illustrated in Fig. 4. The LED package 150 may be a surface-mounted type package product wherein a LED chip equipped with a positive electrode and a negative electrode on its surface which is opposed to a light-emitting surface of the LED chip is in a mounted state on the mounting surface of the substrate in a manner of flip-chip. The LED chip may be one used in a general LED package, and thus it can be suitably selected according to the use application of the LED package. As appropriate, what is called a non-polar LED (i.e., non-polar type LED chip) can be used.

The light-emitting device (i.e., LED package) according to the present invention has the protection element suitably incorporated in the substrate. Thus, the LED in the light-emitting device can be protected from the static electricity and the surge voltage while keeping the inherent characteristic of the LED chip, and also an erroneous action of the LED can be prevented in the light-emitting device.

As illustrated in Fig. 4, the LED package 150 has a phosphor layer 80 formed on the LED chip 20. The phosphor layer 80 may be any one as long as it can produce a desired light by receiving the light from the LED chip 20. In other words, a kind of phosphor material of the phosphor layer may be determined in view of the light or electromagnetic wave from the light-emitting element. For example, in a case where the LED package is used as a white-lightning LED package, bright white color light can be produced when the phosphor layer includes phosphor material capable of generating yellow-based color by the blue color attributed to the LED chip. In another case where the electromagnetic wave emitted from the LED chip is ultraviolet rays, the phosphor material capable of directly producing the white light by such ultraviolet rays may be used.

The LED package 150 illustrated in Fig. 4 is equipped with the metal layers (i.e., patterned wiring layers) 90 disposed on the substrate. It is preferred that the metal layers are provided in an electrical connection with the respective ones of a positive electrode and a negative electrode of the LED chip so as to allow the electrical current to flow through the LED chip. It is also preferred that the metal layers are provided in an electrical connection with the first and second electrodes of the protection element so as to establish a parallel electrical communication between the protection element and the light-emitting element. If required, an electrical continuity may also be established between the metal layer on the upper surface of the substrate and the metal layer on the back surface of the substrate via "via holes", "through holes" or "metal layers which extend around the side face of the substrate". The metal layers provided on the back surface of the substrate may serve for the mounting of the LED package with respect to the other electric component, or may also serve to release the heat as a heat sink.

As seen from the embodiment of Fig. 4, it is preferred in the LED package 150 that the reflective layer 55, which is provided on the substrate 10 or the voltage-dependent resistive layer embedded therein, is adjacent to not only the first electrode 60, but also the above metal layer (i.e., patterned wiring layer) 90. That is, in one preferred embodiment, the surface of the substrate (i.e., the substrate surface including the substrate exposure surface of the voltage-dependent resistive layer) is covered with the reflective layer 55, the first electrode 60 and the patterned wiring layer 90.

As illustrated in Fig. 4, a light-emitting side, i.e., upper side of the LED package 150 is covered with a sealing resin 30. That is, the LED chip 20 and the metal layers 90 are covered as a whole with the sealing resin 30. The sealing resin 30 may be made of any material, e.g., the material used in a general LED package. For example, the sealing resin 30 may be made of a transparent epoxy resin or a translucent white epoxy resin. Preferably, the sealing resin 30 has a lens shape as illustrated in Fig. 4 in order to enhance a utilization efficiency of the light.

Now, the substrate 10 for light-emitting element will be described in more detail. The body 10 of the substrate for light-emitting element may be made of any materials, i.e., may be made of a material which can be used for a substrate of a general LED package. However, in view of an improvement of the heat releasing performance in the light-emitting device, it is preferred that the substrate is made of a material having the desired heat conductivity. Examples of the material having the desired heat conductivity include a metal, a ceramic, a composite material and a thermally conductive filler-containing resin. Among those, the ceramic is particularly suitable material for the substrate on which the light-emitting element generating the heat is mounted, since it has the higher heat conductivity and the less thermal expansion coefficient. Further in light of the fact that the ceramic substrate (e.g., LTCC substrate) can be obtained with ease by sintering the green sheet, the ceramic is suitable material for the substrate in the present invention.

In the light-emitting device of the present invention, a size of the substrate is relatively small since the voltage-dependent resistive layer of the protection element has not been disposed on the surface of the substrate, but embedded within the body of the substrate (specifically, at the mounting region for the light-emitting element). For example in a case of producing an LED package 150 as illustrated in Fig. 4, a size of the main surface (i.e., width "W" and length "L" in Fig. 2) is preferably decreased by 30% to 80%, more preferably by 40% to 70%, most preferably by 50% to 70% in comparison with that of the conventional LED package 200 as illustrated in Fig. 24. As a mere example of the size of the main surface, the conventional compact LED package of Fig. 24 has a size of the main surface in about 2.5 mm to about 4.0 mm × about 2.5 mm to 4.0 mm, whereas the LED package of the present invention can have the size of the main surface in about 1.0 mm × about 1.0 mm, which corresponds to the same shape as that of the LED element. Therefore, the substrate 10 for light-emitting element can be largely scaled down, and thereby the down-sizing of the light-emitting device (i.e., LED package) can be suitably achieved.

According to the present invention, a thin substrate is provided as the light-emitting element substrate in which the protection element is accommodated. For example in a case of the LED package 150 of Fig. 4, a thickness of the substrate body 10 can be in the range of about 150 µm to about 400 µm. This comparative thinning of the substrate can lead to a suitable thinning of the light-emitting device (i.e., LED package).

A voltage-dependent resistive layer 50 of the protection element, which is in an embedded in the substrate, may be made of any material as long as the resistance of the layer 50 varies according to a voltage applied thereto. In a case where the protection element is a varistor element, it is typical that the voltage-dependent resistive layer 50 is a layer made of a varistor material. In this regard, the voltage-dependent resistive layer 50, which is made of the varistor material, may be in a form of singular layer as illustrated in Fig. 4. The single layer of the voltage-dependent resistive layer 50 can achieve an accommodating/embedding of the protection element in the substrate without increasing of the substrate thickness. The varistor material for the voltage-dependent resistive layer may be any suitable ones, and thus it may be a material generally used for a chip varistor. For example, a metal-oxide-based material mainly composed of zinc oxide (ZnO) or strontium titanate (SrTiO₃) can be used as the varistor material. Particularly, the zinc oxide (ZnO) has a satisfactory ability to protect the light-emitting element from a surge and the like since the resistance value of the zinc oxide significantly varies according to the value of the applied voltage. Therefore, the zinc oxide can be suitably used as a material for the voltage-dependent resistive layer in the present invention.

The size of the voltage-dependent resistive layer 50 is not particularly limited as long as it is smaller than that of the substrate. In other words, it is preferred that the horizontal width dimensions of the voltage-dependent resistive layer are smaller than those of the main surface of the substrate. For example, a width dimension "w" of the voltage-dependent resistive layer 50 as illustrated in Fig. 1 is preferably in the range of about 20% to about 70% of a width dimension "W" of the substrate, more preferably in the range of about 30% to about 60% thereof. A thickness dimension "t" of the voltage-dependent resistive layer 50 as illustrated in Fig. 1 is preferably in the range of about 10% to about 50% of a thickness dimension "T" of the substrate, more preferably in the range of about 10% to about 40% thereof. The thickness of the voltage-dependent resistive layer can have a correlation with a varistor voltage (in a case where the protection element is the varistor element). Therefore, the thickness of the voltage-dependent resistive layer may be determined according to a desired varistor voltage. For example in a case where the light-emitting element is an LED, the desired varistor voltage is about 10 V or less. In this case, the thickness of the voltage-dependent resistive layer may be determined so as to achieve the varistor voltage of about 10 V or less. In order to protect the light-emitting element from the static electricity, an electrostatic capacitance is required to some extent in the voltage-dependent resistive layer (i.e., varistor layer). As the voltage-dependent resistive layer becomes thinner, the electrostatic capacitance becomes larger. Therefore, the thickness of the voltage-dependent resistive layer can be determined according to the desired electrostatic capacitance.

In the substrate 10 for light-emitting element, a surface of the voltage-dependent resistive layer 50 is preferably positioned in the same plane as the surface of the substrate as illustrated in Fig. 2. More specifically, an upper surface of the voltage-dependent resistive layer 50 is exposed from the substrate so as to be flush with the surface of the substrate. A light-emitting element 20 is to be positioned such that it at least partially overlaps with the substrate exposure surface of the voltage-dependent resistive layer 50. This means that at lease a part of the upper surface of the voltage-dependent resistive layer 50 is exposed at the mounting region for the light-emitting element in the substrate. On the substrate exposure surface of the voltage-dependent resistive layer 50, there is provided the reflective layer 55 as illustrated in Fig. 2.

In the present invention, the voltage-dependent resistive layer 50 is in an exposed state at the surface of the substrate wherein the size of the exposed surface of the resistive layer is relatively small. Preferably, the exposed surface of the voltage-dependent resistive layer 50 has a smaller area than that of the mounting region 25 of the light-emitting element (see, Fig. 1 and the other drawings). For example, the exposed area of the voltage-dependent resistive layer 50 is smaller than that of the mounting region 25 for the light-emitting element preferably by the range of about 20% to about 70%, more preferably by the range of about 30% to about 60%. Since the size of the main surface of the voltage-dependent resistive layer embedded in the substrate body with being flush therewith is smaller than the size of the main surface of the light-emitting element, an adverse effect of a contraction stress upon the sintering of the material for the substrate becomes less, and thereby the warping of the substrate can be effectively reduced. This leads to a precise mounting of the light-emitting element wherein it can be precisely mounted in a manner of flip-chip. Further, a zinc oxide varistor (i.e., the zinc oxide of the voltage-dependent resistive layer) has less bending strength, and thus, by forming the voltage-dependent resistive layer into a size smaller than the size of the main surface of the light-emitting element, the bending strength can be improved as a whole in the package. This means that the package can possess a resistance to a pressure stress upon the flip-chip mounting. Furthermore, in light of the fact that the voltage-dependent resistive layer is relatively expensive, the smaller size of the voltage-dependent resistive layer can lead to the cost saving without impairing the essential performance of the varistor.

The material for each of the first electrode and the second electrode of the protection element is not particularly limited, and thus may be typical one used for the conventional protection element. For example in a case where the protection element is a varistor element, any typical material used for the varistor electrode can be used for the first electrode and the second electrode of the varistor element. For example, at least one of metal materials selected from the group consisting of silver (Ag), copper (Cu), palladium (Pd), platinum (Pt) and nickel (Ni) can be used as a main material of the first electrode and the second electrode of the varistor element.

The first electrode 60 may be one formed through a plating process (e.g., dry plating process and/wet plating process). For example, the first electrode 60 may be one formed by sputtering and electroplating processes. In this regard, the first electrode 60 may be composed of a sputtering film layer as a foundation layer, and a thick plating layer formed thereon.

Each size of the first electrode 60 and the second electrode 70 of the protection element is not largely limited. In other words, as illustrated in Fig. 3, as long as the first electrode 60 is provided so as to be in contact with the substrate exposure surface (i.e., "surface of the voltage-dependent resistive layer" being flush with a surface of the substrate) of the voltage-dependent resistive layer 50 and the second electrode 70 is provided so as to be in contact with the substrate embedment surface of the voltage-dependent resistive layer 50 in an opposed relation to the first electrode 60, there is no limitation in the sizes of the first electrode 60 and the second electrode 70. For example in a case of the configuration illustrated in Fig. 1, a width dimension "w1" of the first electrode 60 may be in the range of about 0.2 mm to about 1.0 mm (for example about 0.2 mm to about 0.5 mm), and a width dimension "w2" of the second electrode 70 may be in the range of about 0.3 mm to about 0.5 mm, whereas a thickness dimension "t1" of the first electrode 60 may be in the range of about 50 µm to about 150 µm, and a thickness dimension "t2" of the second electrode 70 may be in the range of about 5 µm to about 20 µm.

The substrate 10 for light-emitting element has such a configuration that the protection element (especially, voltage-dependent resistive layer and the second electrode which occupy a larger volume) is substantially eliminated from the surface of the substrate, making it possible to give a space for other components. Therefore, the present invention can make the first electrode 60 thicker. For example, the thickness of the first electrode can be preferably in the range of about 50 µm to about 200 µm, more preferably in the range of about 60 µm to about 150 µm, most preferably in the range of about 70 µm to about 125 µm. Since the first electrode effectively contributes to the heat releasing because of its high thermal conductivity, the thicker first electrode can effectively improve the heat-releasing effect in the product with the light-emitting element provided therein. Similarly, the present invention can make the larger thickness of the wiring pattern (i.e., patterned metal layer) and the like provided on the mounting surface of the substrate. For example, the thickness of the wiring patter or the like can be in the range of about 50 µm to about 200 µm, preferably in the range of about 60 µm and about 150 µm, and more preferably in the range of about 70 µm to about 100 µm.

In a case where the protection element is the varistor element, the substrate 10 for light-emitting element can be configured to have "double-varistor structure" as illustrated in Fig. 2. In the "double-varistor structure", as illustrated in Fig. 2, the first electrode 60 has a divided form wherein the divided two pieces (i.e., 60a and 60b) are positioned on the substrate exposure surface of the voltage-dependent resistive layer 50, whereas the second electrode 70 is composed of two sub-electrodes 70a, 70b in a serial connection with each other to integrally posses them on the substrate embedment surface of the voltage-dependent resistive layer 50. Particularly, it is preferred that the second electrode 70 composed of the two sub-electrodes 70a and 70b has a form of a singular layer as a whole, as illustrated in Fig. 3. The "double-varistor structure" can improve the varistor performance while providing the substrate with a relatively simple configuration. Therefore, the "double-varistor structure" is suitable as a substrate structure in the package. Further, with respect to the "double-varistor structure", it has a form of the two varistor elements substantially embedded in the substrate at the light-emitting element mounting region in spite of the serial interconnection of the two varistor elements. This leads to a suitable down-sizing and thinning of the LED package as a whole. The substrate with the varistor structure is also characterized in that the electrodes can be disposed in the surface layer of the substrate with a remarkably simple structure.

The light-emitting device of the preset invention can be realized as LED package products according to various modified embodiments. The detailed explanation about this will be described.

### (Substrate back face-embedment of voltage-dependent resistive layer)

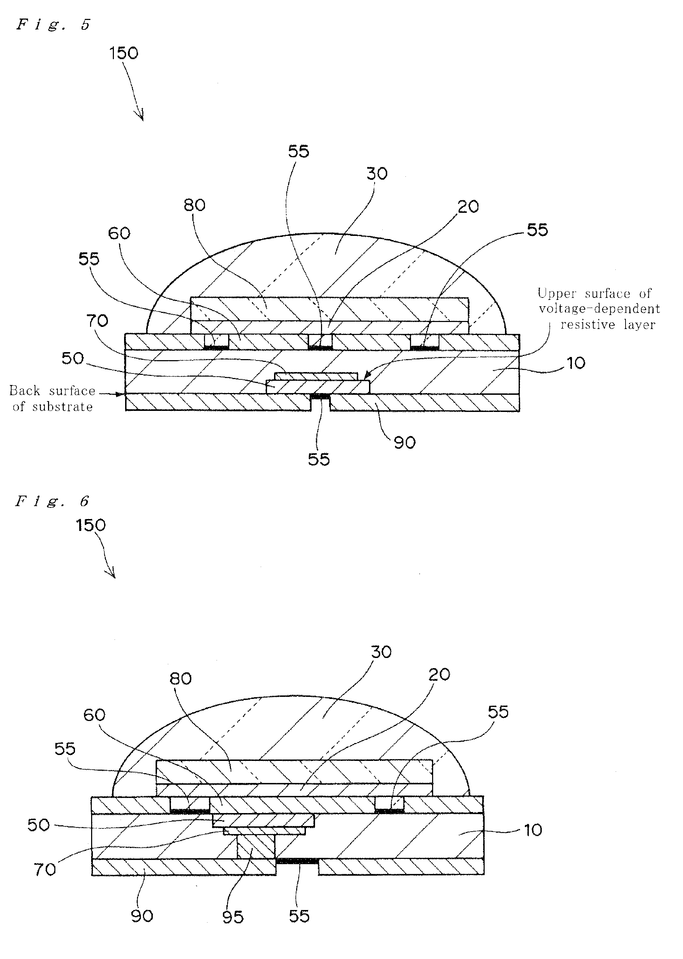

Fig. 5 illustrates the LED package 150 according to an embodiment "substrate back face-embedment of voltage-dependent resistive layer". As illustrated in Fig. 5, the voltage-dependent resistive layer 50 of the protective device (e.g., varistor element) is embedded such that the resistive layer 50 is flush with the back face of the substrate. In other words, the voltage-dependent resistive layer 50 is in the same plane with the bottom surface of the substrate. The second electrode 70 is positioned in contact with the upper surface of the voltage-dependent resistive layer 50. In this LED package, the electrical continuity is established between "metal layers on the top surface of the substrate" and "metal layers on the bottom surface of the substrate" by means of the via holes, the through holes or the metal layers extending around the side surface of the substrate. As seen from the embodiment of Fig. 5, the reflective layers 55 are located on the voltage-dependent resistive layer 50 and the body of the substrate 10 such that they are adjacent to not only the first electrode 60 but also the patterned wiring layer 90. According to this embodiment, the LED package can be kept at a lower temperature, compared with the case of the package with the voltage-dependent resistive layer embedded immediately below the light-emitting element, and thereby a current leakage attributed to the temperature of the voltage-dependent resistive layer can be prevented, which leads to an improved efficiency in the package.

### (Through Electrode)

Fig. 6 illustrates the LED package 150 according to an embodiment "through-electrode". As illustrated in Fig. 6, the second electrode 70 positioned in interior of the substrate is in a connection with the electrode and the metal layers 90 positioned on the back surface of the substrate by means of the via holes 95 extending in the interior of the substrate between the voltage-dependent resistive layer 50 and the back surface of the substrate. The reflective layers 55 are located on the voltage-dependent resistive layer 50 and the body of the substrate 10 such that they are adjacent to not only the first electrode 60 but also the patterned wiring layer 90. According to this embodiment, there is provided an advantageous effect wherein the voltage-dependent resistive layer is not exposed at the surface of the substrate, and thereby the deterioration of the resistance property can be prevented upon subjecting the electrode layer to the Auplating treatment. Further, another advantageous effect is also provided wherein the increased throughput can be prevented since the through electrode can be formed by a process which is the same as a through-hole formation process for establishing the electrical connection between the through hole and the electrode serving as an electrical connection with the mounting surface side.

### (Disposition in recessed-portion)

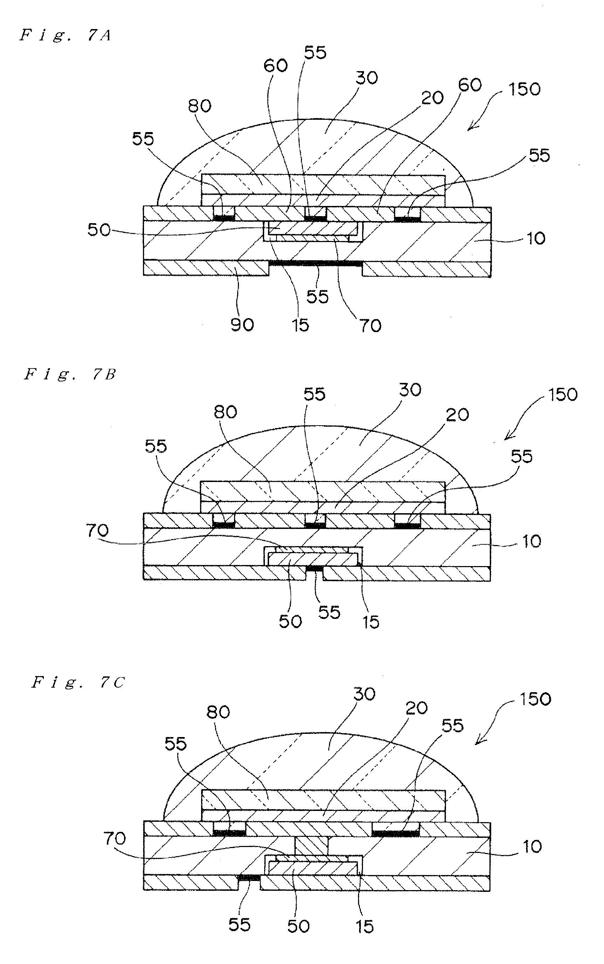

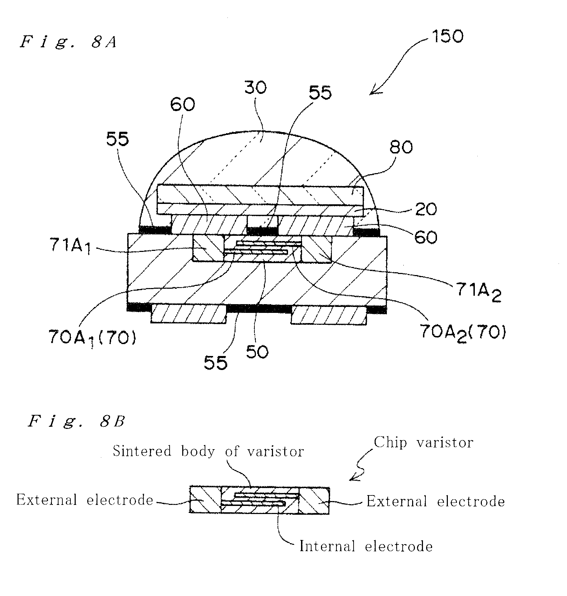

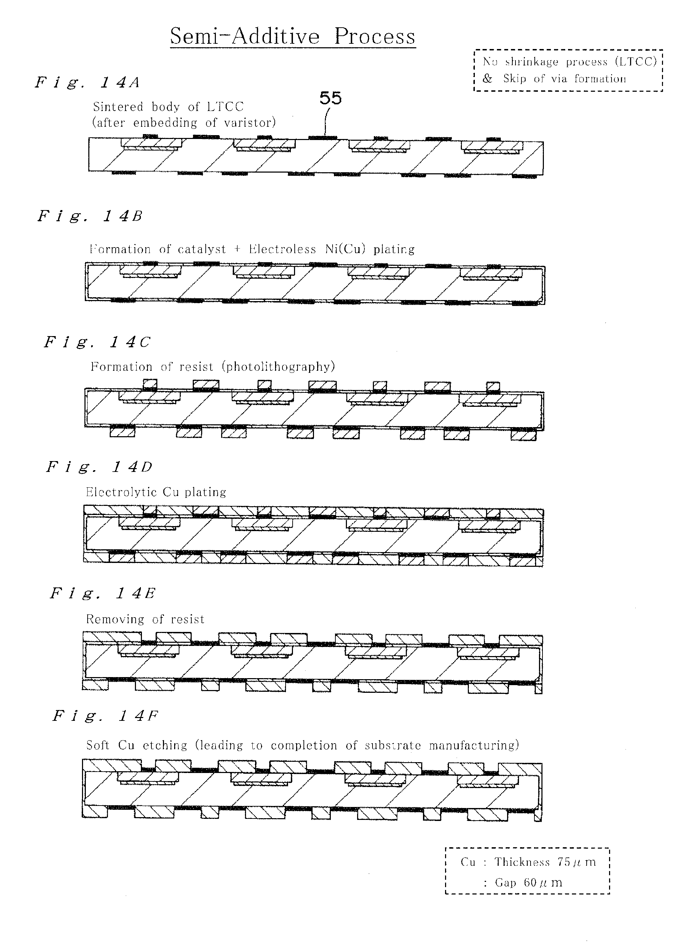

Figs. 7A to 7C illustrate the LED package 150 according to an embodiment "disposition in recessed-portion". As illustrated, the voltage-dependent resistive layer 50 and the second electrode 70 are provided within a recessed portion 15 formed in the main surface of the substrate. The LED package 150 according to the embodiment "disposition in recessed-portion" is substantially the same as the embodiment described above, but it has a characteristic feature attributed to a difference in the manufacturing process. More specifically, the LED package having the above described configuration is obtained by embedding the voltage-dependent resistive layer 50 and a second electrode precursor layer 70' in a green sheet 10', followed by the sintering of the green sheet 10' (for example, see the following description with reference to Figs. 8A and 8B), while on the other hand, the LED package 150 according to the embodiment "disposition in recessed-portion" is obtained by using of the substrate (sintered substrate) with the recessed portion 15 formed in advance (see the following description with reference to Figs. 14A to 14F). Therefore, according to the embodiment "disposition in recessed-portion", there is provided an advantageous effect wherein the voltage-dependent resistive layer 50 is not substantially affected by the heat and thus a better performance of the protection element can be provided. The reflective layers 55 are located on the voltage-dependent resistive layer and the body of the substrate such that they are adjacent to not only the first electrode but also the patterned wiring layer.

With respect to the embodiment "disposition in recessed-portion", a configuration of Fig. 7A corresponds to the configurations of Figs. 1 through 3. A configuration of Fig. 7B corresponds to the configuration of Fig. 5. A configuration of Fig. 7C corresponds to a combination of the configurations of Figs. 5 and 6.

The following embodiments are also possible in the present invention.

### (Built-in multilayer varistor)

Fig. 8A illustrates the LED package 150 according to an embodiment "built-in multilayer varistor". As illustrated, the voltage-dependent resistive layer 50 has a substantially laminated form. More specifically, a plurality of interior electrodes (70A₁ and 70A₂) are positioned within the voltage-dependent resistive layer 50, and external electrodes (71A₁ and 71A₂) positioned outside the voltage-dependent resistive layer 50 are in an electrical connection with the internal electrodes (70A₁ and 70A₂). In this embodiment, the internal electrodes (70A₁ and 70A₂) correspond to the second electrode of the present invention. The LED package 150 according to the embodiment "built-in multilayer varistor" can be obtained through the embedding of a chip varistor of Fig. 8B into the substrate. According to this embodiment, there is provided an advantageous effect wherein a large static electricity withstand can be provided due to the large electrode area of the multilayer varistor. The reflective layers 55 are located on the voltage-dependent resistive layer 50 and the body of the substrate 10 such that they are adjacent to the first electrode 60.

### (Embedding of second electrode in the interior of voltage-dependent resistive layer)

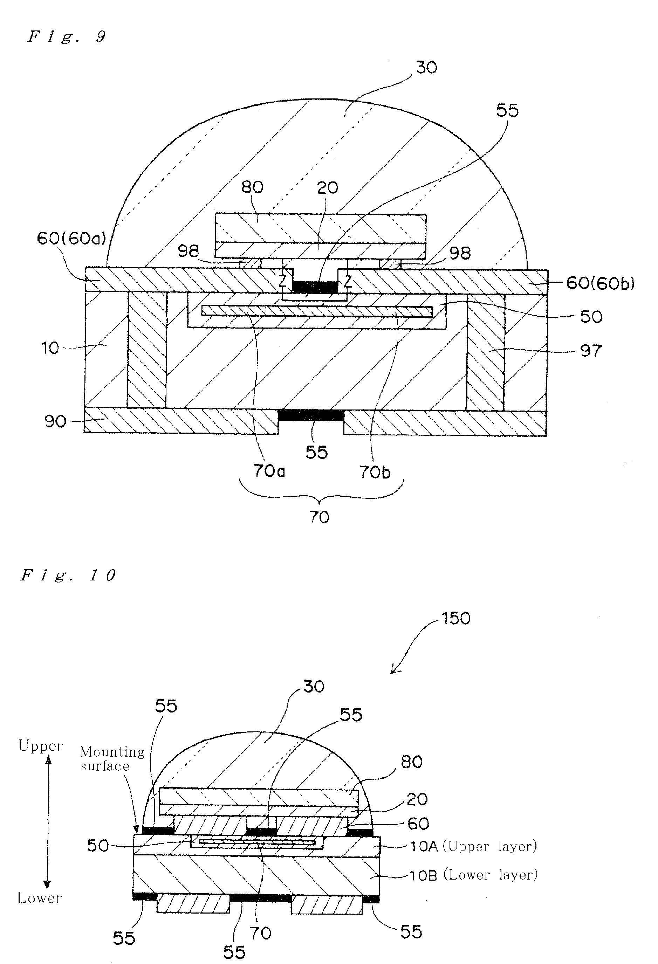

Fig. 9 illustrates the LED package 150 according to an embodiment "embedding of second electrode in the interior of voltage-dependent resistive layer". As illustrated, the second electrode 70 is in an embedded state within the voltage-dependent resistive layer 50. Namely, according to the embodiment, the first electrode 60 is positioned in contact with the substrate exposure surface of the voltage-dependent resistive layer 50, whereas the second electrode 70 is positioned in the interior of the voltage-dependent resistive layer 50. This embodiment can also provide the package with the "double-varistor structure". As illustrated in Fig. 9, the first electrode 60 has a divided form wherein the two pieces (60a and 60b) of the divided electrode are positioned on the substrate exposure surface of the voltage-dependent resistive layer 50, whereas the second electrode 70 is composed of two sub-electrodes 70a, 70b in a serial connection with each other to integrally posses them in the interior of the voltage-dependent resistive layer 50 (it is preferred in this embodiment that the second electrode 70 composed of the two sub-electrodes 70a and 70b has a form of a singular layer as a whole, as illustrated in Fig. 9). According to this embodiment wherein the second electrode 70 is in an embedded state in the interior of voltage-dependent resistive layer, there is provided an advantageous effect wherein a deterioration of the varistor performance, which is attributed to the diffusion of the material of the substrate, can be effectively prevented. Further, another advantageous effect is also provided wherein a varistor voltage can be substantially reduced in the double-varistor structure, and an electrostatic capacitance thereof can be increased. The second electrode 70 embedded in the interior of the voltage-dependent resistive layer 50 is not necessarily a singular one, but may be a plural. One example of the plurality of second electrodes 70 embedded in the interior of the voltage-dependent resistive layer 50 can correspond to the above described embodiment "built-in multilayer varistor". The reflective layers 55 are located on the voltage-dependent resistive layer 50 and the body of the substrate 10 such that they are adjacent to the first electrode 60.

### (Heterogeneous ceramic substrate)

Fig. 10 illustrates the LED package 150 according to the embodiment "heterogeneous ceramic substrate". In this embodiment, the body of the substrate is made of a plurality of material layers which differ from each other. In Fig. 10, the LED package has a two-layered structure composed of an upper layer 10A and a lower layer 10B. The upper layer 10A, in which the voltage-dependent resistive layer 50 is disposed, is made of a low-temperature sintered material (e.g., a glass ceramic), whereas the lower layer 10B is made of a high-temperature sintered material (e.g., an alumina or an aluminum nitride). In this case, the low-temperature sintered material layer as the upper layer 10A can be obtained by a low-temperature sintered process (for example, about 900°C process), and is preferable in terms of the embedding of the voltage-dependent resistive layer 50 (i.e., varistor) into the substrate. On the other hand, the high-temperature sintered material layer as the lower layer can exhibit a higher conductivity and thus it can provide the substrate with excellent heat-releasing performance (heat conductivity of glass ceramic substrate layer: 3 to 5 W/mK, heat conductivity of alumina substrate layer: 10 to 20 W/mK, and heat conductivity of aluminum nitride substrate layer: 100 to 230 W/mK). The heterogeneous substrate illustrated in Fig. 10 (e.g., heterogeneous substrate composed of the glass ceramic substrate layer as the upper layer and the alumina substrate layer as the lower layer) can be obtained through an embedding process of a sintered varistor body into a multilayered structure composed of a "green sheet for a substrate of the low-temperature co-fired ceramic (LTCC)" provide on the fired alumina substrate (i.e., the alumina substrate obtained by the sintering process). The reflective layers 55 are located on the voltage-dependent resistive layer 50 and the body of the substrate 10 such that they are adjacent to the first electrode 60.

### [Manufacturing Method of Light-emitting Device according to the Present Invention]

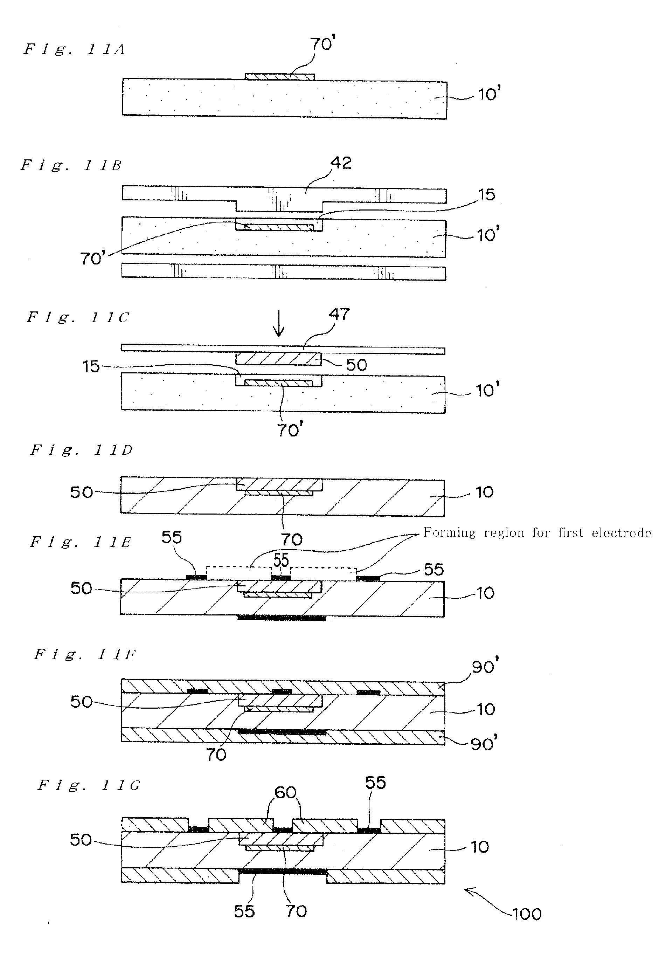

Next, a method for manufacturing the light-emitting device according to the present invention will be described. Figs. 11A through 11G illustrate a process for carrying out the manufacturing method of the present invention.

The manufacturing method described below is based on "method for manufacturing a substrate for light-emitting element, the substrate being equipped with a varistor element comprising a voltage-dependent resistive layer and first and second electrodes electrically connected to the voltage-dependent resistive layer". Firstly, as illustrated in Fig. 11A, a second electrode precursor layer 70' is formed on one main surface of a green sheet (s) 10' for the substrate. For example, the second electrode precursor layer 70' can be obtained by applying a Ag electrode paste on the green sheet, followed by drying thereof. Subsequent to the formation of the second electrode precursor layer 70', the second electrode precursor layer 70' is pressed into the green sheet by using a convex-shaped die 42, as illustrated in Fig. 11B. The pressing can form a recessed portion 15 in the green sheet 10' while disposing the second electrode precursor layer 70' on a bottom surface of the recessed portion 15. Subsequently, as illustrated in Fig. 11C, a carrier film 47 with the voltage-dependent resistive layer 50 carried thereon is used. By using such carrier film 47, the voltage-dependent resistive layer 50 can be disposed in the recessed portion 15 of the green sheet 10'. More specifically, the voltage-dependent resistive layer 50 is disposed on the second electrode precursor layer 70' in the recess portion 15 such that the resistive layer 50 is stacked on the electrode precursor layer 70'. Thereafter, the green sheet 10' with the second electrode precursor layer 70' and the voltage-dependent resistive layer 50 disposed in the recessed portion thereof is subjected to a sintering process. As a result, as illustrated in Fig. 11D, the substrate 10 with the voltage-dependent resistive layer 50 and the second electrode 70 embedded therein is obtained (in this regard, the second electrode 70 is formed from the second electrode precursor layer 70' by the sintering process). It is preferred that the sintering process is performed by making use of "method of reducing a shrinkage phenomenon upon the sintering" as discussed in JP-A-04-243978 and JP-A-05-102666. According to the reducing method of the shrinkage phenomenon, there can be obtained the substrate 10 in which the voltage-dependent resistive layer 50 and the second electrode 70 are accurately embedded therein. Specifically, the reducing method of the shrinkage phenomenon can especially suppress the shrinkage in a planer direction, in which case the shrinkage occurs only in a thickness direction. For example, the shrinkage occurs by about 15% in an X-Y-Z direction in the conventional sintering method of the green sheet. While on the other hand, the reducing method of the shrinkage phenomenon allows the degree of shrinkage in the planar direction (i.e., X-Y) to be almost 0% (i.e., about 0.05%) wherein the shrinkage occurs by the degree of about 40% only in the thickness direction (Z). The manufacturing method of the present invention is characterized in that the voltage-dependent resistive layer which has been already sintered can be used. If a case where the "green sheet with the voltage-dependent resistive layer which has been already sintered therein" is subjected to the sintering process by the conventional sintering method is assumed, there is concern that warping and/or cracks of the resulting substrate may occur because of a shrinkage gap between "region of the voltage-dependent resistive layer, which does not undergo the sintering" and "region other than the voltage-dependent resistive layer, which undergoes the sintering". In view of the above, when the "method of reducing a shrinkage phenomenon upon the sintering" is employed in the present invention, the advantageous effect is provided wherein the warping and/or the cracks of the substrate would not occur due to no shrinkage in the planar direction.

Subsequent to the sintering, the reflective layer 55 is disposed on the substrate 10 and the voltage-dependent resistive layer 50. More specifically, as shown in Fig. 11E, the reflective layer 55 is formed at least at region adjacent to a forming region for the first electrode. As shown in Fig. 11E, it is preferred that the reflective layer 55 (particularly the reflective layer to be adjacent to the first electrode) is formed such that the side face of the reflective layer is in a close contact with the side face of the first electrode 60. In other words, the reflective layer 55 is preferably formed at such a position that the side face of the reflective layer and the side face of the first electrode are finally in contact with each other.

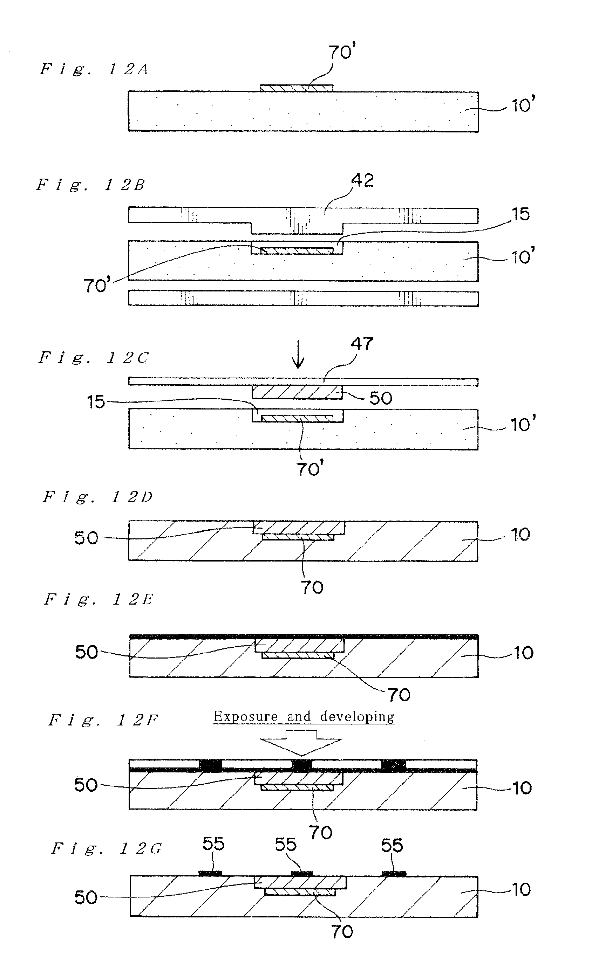

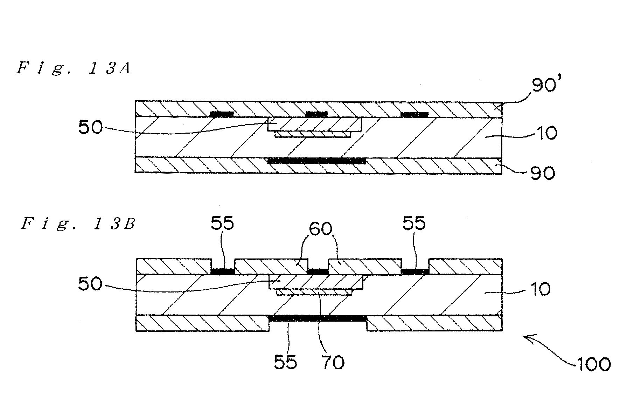

The formation of the reflective layer 55 may be performed by any suitable processes as long as they can produce the reflective layer 55 locally at region adjacent to the forming region for the first electrode. The reflective layer 55 can be formed by applying a raw material therefor on the entire surface of the substrate 10, followed by a mask exposure process and a subsequent development process (see Figs. 12A-12G and 13A-13B, especially Figs. 12A-12G). It is preferred in this case that the raw material for the reflective layer 55 is made of a photosensitive material. Alternatively, the formation of the reflective layer may be performed by a printing process (e.g., screen printing process) wherein the raw material for the reflective layer is locally supplied on the substrate.

In a case of the formation of the reflective layer made of the resin component with the oxide ceramic component therein, such a resin material that contains the oxide ceramic powder (e.g., titanium oxide powder and/or alumina powder) therein may be applied, followed by being subjected to a curing treatment (for example, heat curing or photo curing treatment). In another case of the formation of the reflective layer made of the glass component with the oxide ceramic component therein, such a glass paste material (e.g., glass paste made of a vehicle and glass powder such as SiO₂ and B₂O₃ powder) that contains the oxide ceramic powder (e.g., titanium oxide powder and/or alumina powder) therein may be applied, followed by being subjected to a heat treatment.

It is preferred that the thickness of the formed reflective layer 55 is in the approximate range of 1 um to 20 um in terms of "improved reflectivity" and "protection of voltage-dependent resistive layer".

Subsequent to the formation of the reflective layer, the first electrode 60 and the wiring pattern 90 are formed. For example, the metal layer 90' is formed on the main surface of the substrate 10 as illustrated in Fig. 11F. Thereafter, as illustrated in Fig. 11G, the metal layer 90' is subjected to a patterning process to form the first electrode 60 in contact with the voltage-dependent resistive layer 50, and also form the wiring pattern 90. As a result, there can be finally obtained the substrate 10 for light-emitting element.

The first electrode can be formed through the plating process as described below, in which process the reflective layer can serve to protect the voltage-dependent resistive layer 50 from the forming process of the first electrode.

### Formation of First Electrode by Plating Treatment

Figs. 14A to 14F show an example of a method for forming the first electrode and the copper wiring on the substrate by a semi-additive process. In accordance with the semi-additive process, "substrate in which a plurality of voltage-dependent resistive layers are in an embedded state in a form of array", i.e., "substrate in which a plurality of light-emitting elements are in a mounted state in a form of array" can be produced. Fig. 14A illustrates a state that the plurality of voltage-dependent resistive layers are in an embedded state such that they are flush with the surface of the substrate. The whole of the substrate as illustrated in Fig. 14A is dipped into a Pd catalyst solution, followed by drying thereof. The dried substrate is subjected to an electroless nickel plating process (see Fig. 14B). As a result, a thin metal plated layer (i.e., nickel metal layer) is formed on the whole of the substrate. Alternatively, the metal layer may be formed on the substrate by a sputtering process with the use of a copper metal, a nickel metal, titanium metal or an alloy of nickel metal and chrome. Subsequent to the formation of the metal layer, the photo-resists are formed by a photolithography process. Specifically, the photo-resists are formed on the nickel or titanium layer at limited positions where the subsequent electro-copper plating is not intended to be provided, as illustrated in Fig. 14C. The photo-resists can be formed by applying the resist material on the entire surface of the substrate, followed by a mask pattern exposure process and a subsequent development process. It is preferred that the photo-resists have their thickness of 60 µm or more which corresponds to a desired thickness of the copper electrode. Subsequent to the formation of the photo-resists, a thick copper layer is formed by an electro-copper plating process wherein the preliminarily formed nickel layer is used as a common electrode, as illustrated in Fig. 14D. Then, the resists are removed as illustrate in Fig. 14E, and finally a soft etching process is performed on the entire surface of the substrate in Fig. 14F, thereby removing the copper surface portion and a nickel layer beneath thereof to finish the manufacturing of the substrate. As for the case of the electroless nickel plating process, the residual Pd catalyst can be removed by the use of sulfuric acid or hydrochloric acid. As a result, there can be obtained the first electrode and the copper wiring as illustrated in Fig. 14F. According to the semi-additive process, the thick copper electrode (i.e., first electrode) can be formed and a fine gap between electrodes can be provided. In light of the flip-chip mounting of the LED element, a distance between electrodes is desired to be 60 µm or less considering a downsizing of the element. In this case, the electrode is required to have a thickness of 60 µm or more in view of the suitable heat releasing. Therefore, the processes illustrated in Figs. 14A-14F are important in realizing the desired dimension of the electrode (i.e., 60 µm or more) and the required distance between the electrodes (i.e., 60 µm or less).

With respect to the obtained substrate 10, a light-emitting element (e.g., LED chip) is mounted. Specifically, the LED chip is mounted on the substrate to be electrically connected to the substrate element such as the first electrode and the wiring pattern. Preferably, the mounting of the LED chip is performed by a GGI technology. The GGI (Gold-to-Gold Interconnection) technology corresponds to a flip-chip mounting process in which a gold bump provided on a gold pad of the LED chip is connected to a gold pad provided on the substrate by a thermo-compression bonding. The GGI technology provides an advantageous effect in that no reflow and no flux cleaning is performed due to no use of solder bump, and also a satisfactory reliability can be obtained even at high temperature. In the GGI technology, a gold melting may be performed for example by using an ultrasonic wave in addition to the load and heat. After the mounting of the LED chip is completed, the necessary components (e.g., phosphor layer) are formed, followed by the encapsulating of the light-emitting element, the phosphor layer, the wirings and the like with a sealing resin. As a result, there can be obtained the light-emitting device, i.e., LED package 150 as illustrated in Fig. 4.

As for the manufacturing of the substrate 10 for light-emitting element, the sintered voltage-dependent resistive layer can be used. More specifically, a voltage-dependent resistive layer which has been preliminarily subjected to the sintering process can be used as the voltage-dependent resistive layer 50 to be carried by the carrier film 47. Therefore, the voltage-dependent resistive layer 50 is not adversely affected by the subsequent sintering of the green sheet (specifically, the voltage-dependent resistive layer 50 is not chemically adversely influenced from the green sheet 10' upon the sintering thereof), and thereby a high performance of the varistor element can be still provided. Typical examples of the material for the voltage-dependent resistive layer include a zinc oxide type varistor material. The zinc oxide type varistor material can be obtained by adding bismuth oxide, antimony oxide, cobalt oxide and/or manganese oxide by about 0.5 mol% to about 1.0 mol% to the zinc oxide as a main composition, followed by the sintering thereof. In this case, a typical sintering temperature is in the range of about 1200°C to about 1350°C. While on the other hand, the low-temperature co-fired glass ceramic substrate (LTCC) is obtained by the sintering at a temperature of about 900°C. In the light of this, it can be understood that the manufacturing method of the present invention (wherein the sintered voltage-dependent resistive layer is used and the sintering process of the green sheet for forming the LTCC is performed at about 900°C) allows the voltage-dependent resistive layer to be hardly influenced by the LTCC sintering, making it possible to keep the high varistor performance. The term *"high varistor performance"* as used herein specifically means that "clamping voltage characteristic is excellent" and "less electric current is leaked to the varistor upon the driving of the LED". Incidentally, the phrase *"clamping voltage characteristic is excellent"* specifically means that the voltage-dependent resistive layer is stable with respect to the voltage to be continuously applied and the fluctuation thereof, and that a possible surge voltage can be reduced to a level equal to or less than a withstand voltage of the LED.

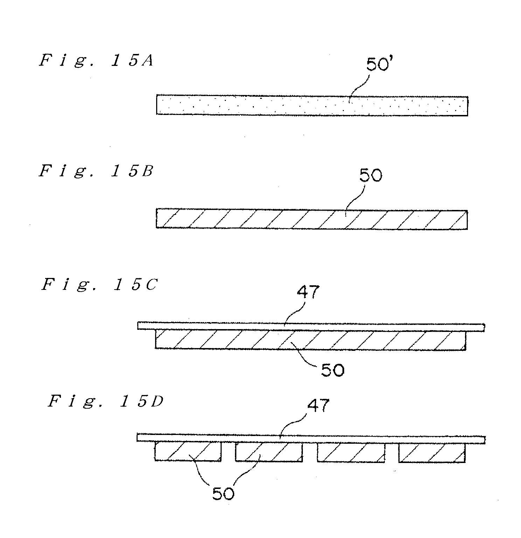

With respect to the carrier film 47 with the voltage-dependent resistive layer 50 disposed thereon, the manufacturing process thereof is illustrated in Figs. 15A through 15D. Firstly, a green sheet 50' capable of forming the voltage-dependent resistive layer is prepared (see Fig. 15A). Next, the green sheet 50' is subjected to a sintering process to form the voltage-dependent resistive layer 50 therefrom (see Fig. 15B). Subsequently, as illustrated in Fig. 15C, the voltage-dependent resistive layer 50 and the carrier sheet 47 are laminated on each other. As a result, there can be obtained the carrier film 47 with the voltage-dependent resistive layer 50 disposed thereon. In a case where a plurality of voltage-dependent resistive layers 50 embedded in the substrate are manufactured, the voltage-dependent resistive layers 50 may be processed to have a form illustrated in Fig. 15D. Alternatively, another process may be possible wherein a plurality of green sheets 50' capable of forming the voltage-dependent resistive layer are prepared by press-cutting the lamination of the green sheets having a desired thickness into pieces of a desired size by means of a thin cutter, and the resulting plurality of green sheets 50' (i.e., unsintered precursor layers of the voltage-dependent resistive layers) are sintered, and thereafter the resulting voltage-dependent resistive layers are disposed on the carrier film.

Various modified embodiments may be possible with respect to the manufacturing method of the present invention. The detailed explanation about this will be described.

### (Direct pressing 1)

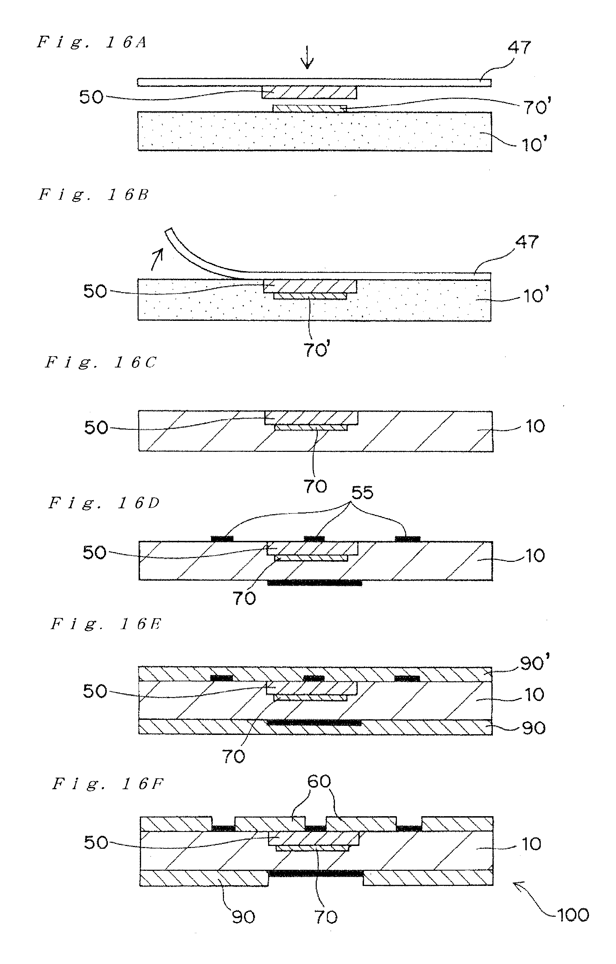

Figs. 16A through 16F schematically illustrate the manufacturing process of the present invention according to an embodiment "direct pressing 1". In this embodiment, a second electrode precursor layer 70' is formed on a main surface of the green sheet 10'. After that, as illustrated in Fig. 16A, the voltage-dependent resistive layer 50 disposed on the carrier film 47 is pressed into the green sheet via the second electrode precursor layer 70'. This makes it possible to form a recessed portion in the green sheet while disposing the voltage-dependent resistive layer 50 and the second electrode precursor layer 70' in the recessed portion thus formed, as illustrated in Fig. 16D. In other words, the voltage-dependent resistive layer 50 and the second electrode precursor layer 70' are forced to be embedded into the green sheet 10' by an application of an external force thereto. The subsequent processes performed after the embedding of the resistive layer 50 and the precursor layer 70' are similar to the above described manufacturing method wherein the sintering of the green sheet 10' is performed to produce the substrate 10 with the voltage-dependent resistive layer 50 and the second electrode 70 embedded therein (see Fig. 16C), and then the reflective layer 55 is formed (see Fig. 16D). Thereafter, the metal layer 90 is formed (see Fig. 16E), and the formed metal layer 90 is subjected to a patterning process to form the first electrode 60 in contact with the voltage-dependent resistive layer 50 (see Fig. 16F).

### (Direct pressing 2)

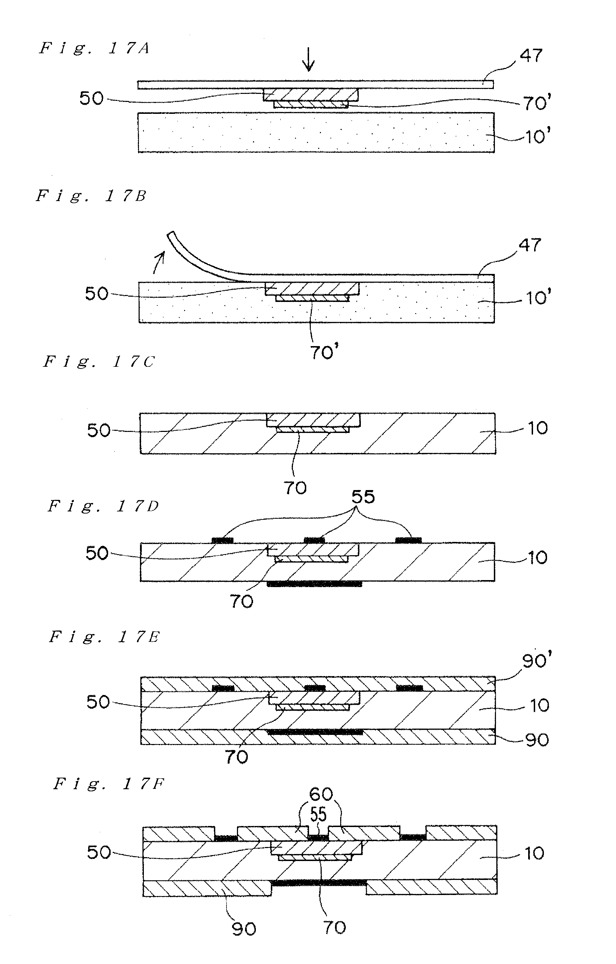

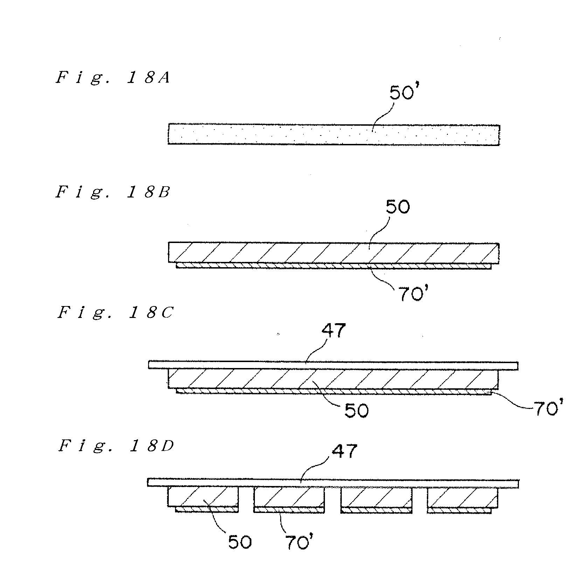

Figs. 17A through 17F schematically illustrate the manufacturing process of the present invention according to an embodiment "direct pressing 2". In this embodiment, the carrier film 47 with the voltage-dependent resistive layer 50 and the second electrode precursor layer 70' disposed thereon is used, as illustrated in Fig. 17A. With respect to manufacturing process of such carrier film with the resistive layer and the precursor layer formed thereon, see Figs. 18A through 18D. The carrier film 47 with the voltage-dependent resistive layer 50 and the second electrode precursor layer 70' thereon is pressed into the green sheet under such a condition that the second electrode precursor layer 70' is positioned at a lower side. This pressing makes it possible to form a recessed portion in the green sheet while disposing the voltage-dependent resistive layer 50 and the second electrode precursor layer 70' in the recessed portion, as illustrated in Fig. 17B. In other words, the voltage-dependent resistive layer 50 and the second electrode precursor layer 70' are forced to be embedded into the green sheet 10' by an application of an external force thereto. The subsequent processes performed after the embedding of the resistive layer 50 and the precursor layer 70' are similar to the above described manufacturing method wherein the sintering of the green sheet 10' is performed to produce the substrate 10 with the voltage-dependent resistive layer 50 and the second electrode 70 embedded therein (see Fig. 17C), and then the reflective layer 55 is formed (see Fig. 17D). Thereafter, the metal layer 90 is formed (see Fig. 17E), and the formed metal layer 90 is subjected to a patterning process to form the first electrode 60 in contact with the voltage-dependent resistive layer 50 (see Fig. 17F).

### (Disposition in recessed-portion)

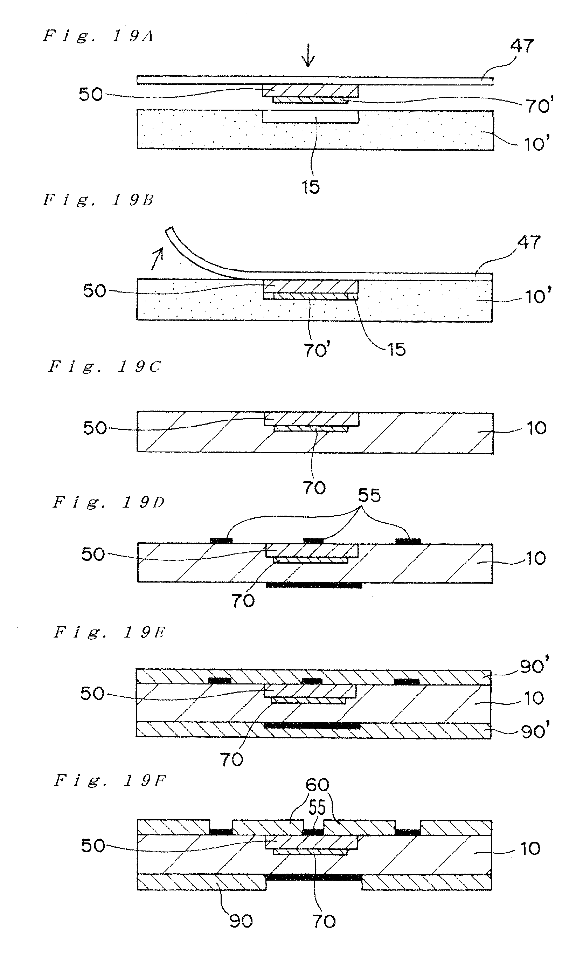

Figs. 19A through 19F schematically illustrate the manufacturing process of the present invention according to an embodiment "disposition in recessed-portion". As illustrated in Fig. 19A, this embodiment is characterized by the use of the green sheet 10' having the recessed portion 15 in advance. The green sheet 10' with the recessed portion 15 beforehand provided therein can be produced by pressing a convex-shaped die into the green sheet 10' through the main surface thereof. Subsequent to the formation of the recessed portion in the green sheet, the voltage-dependent resistive layer 50 and the second electrode precursor layer 70' provided on the carrier film 47 are disposed in the recessed portion 15 of the green sheet 10', as illustrated in Fig. 19B. The subsequent processes performed after the disposition of the resistive layer 50 and the precursor layer 70' are similar to the above described manufacturing method wherein the sintering of the green sheet 10' is performed to produce the substrate 10 with the voltage-dependent resistive layer 50 and the second electrode 70 embedded therein (see Fig. 19C), and then the reflective layer 55 is formed (see Fig. 19D). Thereafter, the metal layer 90 is formed (see Fig. 19E), and the formed metal layer 90 is subjected to a patterning process to form the first electrode 60 in contact with the voltage-dependent resistive layer 50 (see Fig. 19F).

### (Sintered substrate with recessed-portion)

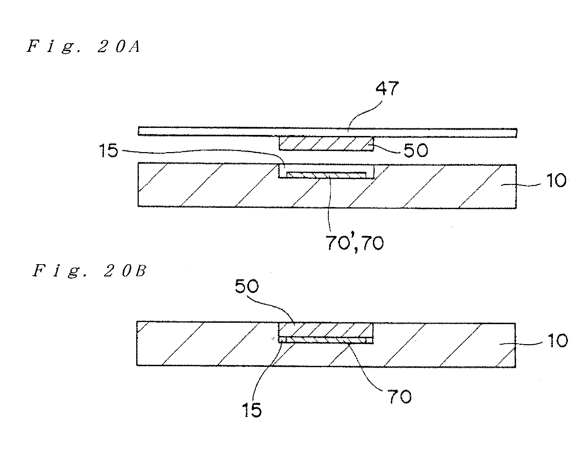

Figs. 20A and 20B schematically illustrate the manufacturing process of the present invention according to an embodiment "sintered substrate with recessed-portion". This embodiment is characterized by the use of the sintered substrate having the recessed portion in advance. The use of this substrate 10 can produce the light-emitting element substrate of the present invention only by disposing the second electrode precursor layer 70' and the voltage-dependent resistive layer 50 in the recessed portion 15, followed by a heating treatment of precursor layer to form the second electrode, as illustrated in Figs. 20A and 20B. Instead of the second electrode precursor layer 70', the preliminarily sintered second electrode 70 may be disposed in the recessed portion 15 of the sintered substrate, which also makes it possible to produce the light-emitting element substrate of the present invention. In this case, the voltage-dependent resistive layer 50 disposed in the recessed portion is not thermally affected, and thereby a high varistor characteristic can be suitably kept. With respect to this embodiment, a glass sealing process may be performed, as required.

### (Use of electrode-accommodated resistive layer)

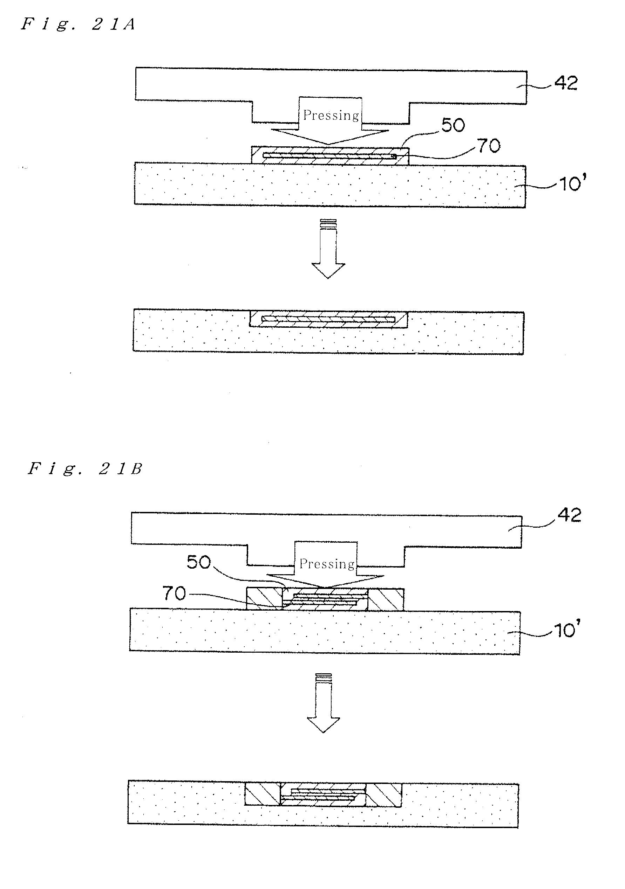

The manufacturing process as illustrated in Figs. 11 through 20 can be applied to a case of the manufacturing process of the substrate for light-emitting element, the substrate being equipped with "voltage-dependent resistive layer having the second electrode accommodated therein" (e.g., the multilayer varistor). For example, the substrate equipped with the voltage-dependent resistive layer 50 having the second electrode 70 accommodated therein can be produced as illustrated in Figs. 21A and 21B. Namely, the "voltage-dependent resistive layer 50 having the second electrode 70 accommodated therein" is disposed on a main surface of the green sheet 10', and thereafter the convex-shaped die 42 is used to press the "voltage-dependent resistive layer 50 having the second electrode 70 accommodated therein" into the green sheet. Such pressing can form the recessed portion in the green sheet 10', while disposing the "voltage-dependent resistive layer 50 having the second electrode 70 accommodated therein" on a bottom surface of the recessed portion. The subsequent processes performed after the disposition of the "voltage-dependent resistive layer 50 having the second electrode 70 accommodated therein" are similar to the above described manufacturing method wherein the sintering of the green sheet is performed to produce the substrate 10 with the voltage-dependent resistive layer and the second electrode embedded therein, and then the reflective layer and the metal layer are formed, and the formed metal layer is subjected to a patterning process to form the first electrode in contact with the voltage-dependent resistive layer. In this embodiment, a performance test of the protection element (i.e., performance test of the varistor) can be carried out prior to the embedding step, which leads to an improved yield in the manufacturing process of the substrate. Further, this embodiment can make use of the varistor obtained individually by the preliminary sintering, and thereby a high varistor performance may be kept after the production of the light-emitting element substrate. The "varistor" tends to exhibit a desired varistor characteristic when the sintering process for forming the varistor element is performed at a higher temperature than a sintering temperature of the green sheet. Therefore, "unsatisfactory sintering (i.e., insufficient firing) of the varistor formation" can be avoided by a case where the sintering of the green sheet is performed with the already-sintered varistor obtained by the sintering at a desired temperature, not the case where the varistor is produced upon the sintering of the green sheet. As a result thereof, there can be finally obtained the light-emitting element substrate with a desired varistor performance.

It should be noted that the present invention as described above includes the following aspects:
The first aspect: A light-emitting device comprising a light-emitting element and a substrate for light-emitting element,
   wherein the light-emitting element is in a mounted state on a mounting surface of the substrate, the mounting surface being one of two opposed main surfaces of the substrate,
   wherein the substrate is provided with a protection element for the light-emitting element, the protection element comprising a voltage-dependent resistive layer embedded in the substrate, and also comprising a first electrode and a second electrode each of which is in connection with the voltage-dependent resistive layer,
   wherein the mounted light-emitting element is in an overlapping relation with the voltage-dependent resistive layer, and
   wherein a reflective layer is provided on at least one of the substrate and the voltage-dependent resistive layer such that the reflective layer is located adjacent to the first electrode which is in contact with a substrate exposure surface of the voltage-dependent resistive layer.
The second aspect: The light-emitting device according to the first aspect, wherein the reflective layer is "insulating layer comprising a resin component and an oxide ceramic component" or "insulating layer comprising a glass component and an oxide ceramic component".
The third aspect: The light-emitting device according to the first or second aspect, wherein the reflective layer serves as a protective layer for protecting the voltage-dependent resistive layer. In this aspect, the reflective layer is preferably provided as the protective layer for protecting the voltage-dependent resistive layer during the manufacturing of the light-emitting device.
The fourth aspect: The light-emitting device according to any one of the first to third aspects, wherein the first electrode has a divided form wherein the divided two pieces of the first electrode are positioned on the surface of the voltage-dependent resistive layer. In other words, the divided two pieces of the first electrode are positioned on the surface of the substrate, the surface including "substrate exposure surface of the voltage-dependent resistive layer" or "mounting surface of the substrate". Since the reflective layer preferably has the insulating properties, the distance between the divided two pieces of the first electrode can be narrowed. For example, in a case where the first electrode has such a divided form that the divided two pieces of the first electrode are positioned on the substrate exposure surface of the voltage-dependent resistive layer, the reflective layer, which is located between the divided two pieces of the first electrode, can have the narrowed width dimension of about 20 µm to about 100 µm.
The fifth aspect: The light-emitting device according to any one of the first to fourth aspects, wherein the reflective layer has a layer thickness of 1 µm to 20 µm. In light of suitable properties of the layer, i.e., not only the reflective property but also the protective property of the layer, the thickness of the reflective layer is preferably in the range of about 1 µm to about 20 µm.
The sixth aspect: The light-emitting device according to any one of the first to fifth aspects, wherein the second electrode is positioned in an opposed relation to the first electrode such that the second electrode is in contact with a substrate embedment surface of the voltage-dependent resistive layer or is accommodated in the interior of the voltage-dependent resistive layer. Preferably in the light-emitting device according to the sixth aspect, the first electrode of the protection element is located on the surface of the substrate such that the first electrode is in contact with the light-emitting element, whereas the second electrode of the protection element is located within the body of the substrate in an opposed relation to the first electrode such that the second electrode is in partial or whole contact with the voltage-dependent resistive layer. For example, the first electrode of the protection element is positioned on the surface of the substrate in contact with the protection element, whereas the second electrode of the protection element, which is opposed to the first electrode, is positioned within the substrate in an overlapping relation with the voltage-dependent resistive layer. Alternatively, the first electrode of the protection element is positioned on the surface of the substrate in contact with the protection element, whereas the second electrode of the protection element, which is opposed to the first electrode, is positioned within the substrate such that the second electrode is included in the interior of the voltage-dependent resistive layer. In this case, the second electrode, which is included in the interior of the voltage-dependent resistive layer, not necessarily have a form of single layer, but may have a form of a plurality of layers.
The seventh aspect: The light-emitting device according to any one of the first to sixth aspects, wherein a surface of the voltage-dependent resistive layer is in the same plane as the one of the two opposed main surfaces of the substrate, and thereby the surface of the voltage-dependent resistive layer forms a part of the mounting surface. In the light-emitting device according to the seventh aspect, the upper surface of the voltage-dependent resistive layer of the protection element is substantially flush with the mounting surface of the substrate. Alternatively, the surface of the voltage-dependent resistive layer may be in the same plane as the other of the two opposed main surfaces of the substrate. This means that the lower surface of the voltage-dependent resistive layer of the protection element may be substantially flush with the back surface of the substrate.
The eighth aspect: The light-emitting device according to any one of the first to seventh aspects, wherein the second electrode is in connection with an electrode or metal layer (or wiring pattern in an electrical communication with such electrode) provided on the one or the other of the two opposed main surfaces (i.e., the mounting surface and back surface opposed thereto) by a via hole which extends in the body of the substrate between the voltage-dependent resistive layer and the one or the other of the two opposed main surfaces. The eighth aspect can correspond to an embodiment wherein the second electrode has a form of "Through Electrode".
The ninth aspect: The light-emitting device according to any one of the first to eighth aspects, wherein the protection element is a varistor element. It is preferred in the light-emitting device according to the ninth aspect that the second electrode is positioned in an opposed relation to the first electrode such that the second electrode is in contact with a substrate embedment surface of the voltage-dependent resistive layer, and that the varistor element is composed of serially-connected two varistor elements which share the second electrode provided on the substrate embedment surface of the voltage-dependent resistive layer. As for the preferred embodiment wherein the protection element is the varistor element, the first electrode of the varistor element has a divided form wherein the divided two pieces of the first electrode are positioned on the surface of the voltage-dependent resistive layer (i.e., "substrate exposure surface of the voltage-dependent resistive layer" or "mounting surface of the substrate"), and the serially-connected two varistor elements share the second electrode provided on the substrate embedment surface of the voltage-dependent resistive layer. This means that the varistor element is composed of a sub-varistor A and a sub-varistor B wherein a first electrode A corresponding to one of the two electrodes of the sub-varistor A and a first electrode B corresponding to one of the two electrodes of the sub-varistor B are positioned on the mounting surface of the substrate. While on the other hand, a second electrode A corresponding to the other of the two electrodes of the sub-varistor A and a second electrode B corresponding to the other of the two electrodes of the sub-varistor B are electrically interconnected in the embedded state within the substrate (it is particularly preferred that the second electrode A of the sub-varistor A and the second electrode B of the sub-varistor B integrally form a single layer). The above structure of the varistor can be referred to as "double-varistor structure" since two of the varistor elements are provided as a component of the substrate. In such "double-varistor structure", a positive electrode of the light-emitting element is to be in connection with one of the divided two pieces of the first electrode, whereas a negative electrode of the light-emitting element is to be in connection with the other of the divided two pieces of the first electrode. Consequently, the two pieces of varistor elements serially connected to each other (i.e., the sub-varistor element A and the sub-varistor element B) are in an electrically parallel connection with the light-emitting element. In one preferred embodiment, the protection element for the light-emitting element is a multilayer varistor. Even in this embodiment, the voltage-dependent resistive layer of the multilayer varistor is preferably in an embedded state at the substrate mounting area for the light-emitting element. It is preferred that a surface of the voltage-dependent resistive layer of the multilayer varistor is in the same plane as the one of the two opposed main surfaces of the substrate, and thereby the surface of such voltage-dependent resistive layer forms a part of the mounting surface in the substrate. This means that, preferably, the upper surface of the voltage-dependent resistive layer of the multilayer varistor is substantially flush with the mounting surface of the substrate.
The tenth aspect: The light-emitting device according to any one of the first to ninth aspects, wherein the substrate has a two-layered structure composed of an upper layer and a lower layer made of different materials from each other. It is preferred in this aspect that the upper layer provides the substrate with the mounting surface, and also has the voltage-dependent resistive layer embedded therein. It is preferred that the upper layer and the lower layer made of different materials from each other have different heat conductivities from each other. In light of the heat releasing from the substrate, it is preferred that the heat conductivity of the lower layer is higher that the heat conductivity of the upper layer. For example, the material for the upper layer of the substrate may be a glass ceramic, whereas the material for the lower layer of the substrate may be an alumina. Alternatively, the material for the upper layer of the substrate may be a glass ceramic, whereas the material for the lower layer of the substrate may be an aluminum nitride.
The eleventh aspect: A method for manufacturing a light-emitting device comprising a substrate for light-emitting element and a light-emitting element mounted on the substrate, the substrate including a varistor element comprising a voltage-dependent resistive layer embedded in the substrate and first and second electrodes each of which is in connection with the voltage-dependent resistive layer, the method comprising the steps of:
   (A) forming a second electrode precursor layer on a main surface of a green sheet;
   (B) pressing the second electrode precursor layer into the green sheet from above by means of a convex-shaped die, and thereby forming a recessed portion in the green sheet with the second electrode precursor layer disposed on a bottom surface of the recessed portion;
   (C) disposing the voltage-dependent resistive layer in the recessed portion;
   (D) sintering the green sheet with the voltage-dependent resistive layer and the second electrode precursor layer disposed in the recessed portion of the green sheet, and thereby producing a substrate with the voltage-dependent resistive layer and the second electrode embedded in the substrate;
   (E) forming a reflective layer on the substrate and/or the voltage-dependent resistive layer; and
   (F) forming the first electrode on the substrate except for a forming region for the reflective layer, the first electrode being in contact with the voltage-dependent resistive layer.
The twelfth aspect: The method according to the eleventh aspect, wherein the reflective layer formed by the step (E) is used for protecting the voltage-dependent resistive layer from the outside during the formation of the first electrode in the step (F).
The thirteenth aspect: The method according to the eleventh or twelfth aspect, wherein the formation of the first electrode in the step (F) is performed by a plating processing in which the reflective layer is used for protecting the voltage-dependent resistive layer from a reagent used for the formation of the first electrode. In other words, in a case where the first electrode is formed through a plating treatment in the step (F), the reflective layer formed by the step (E) is used for the protection of the voltage-dependent resistive layer from a reagent used for such formation of the first electrode. By way of an example, the reflective layer is used for protecting the voltage-dependent resistive layer from an acid liquid (e.g., sulfuric acid or hydrochloric acid) which has been used for removing the impurities or unnecessary matters after the plating treatment (e.g., the residual palladium catalyst of the electroless plating treatment). Such usage of the reflective layer enables the initial properties of the voltage-dependent resistive layer to be maintained due to the fact that the voltage-dependent resistive layer is not impaired during the formation of the first electrode.
The fourteenth aspect: The method according to any one of the eleventh to thirteenth aspect, wherein the first electrode is formed to be in contact with a substrate exposure surface of the voltage-dependent resistive layer in the step (F), and the reflective layer is formed at a region adjacent to a forming region for the first electrode in the step (E). According to this aspect, not only the downward light emitted from the light-emitting element can be effectively reoriented upwardly by the reflective layer, but also the voltage-dependent resistive layer can be suitably protected during the formation of the first electrode by the reflective layer.
The fifteenth aspect: The method according to any one of the eleventh to fourteenth aspect, wherein, instead of the steps (A) and (B), another step is performed wherein a recessed portion is formed in a main surface of a green sheet by means of a convex-shaped die by pushing the die into the green sheet; and
   wherein, in the step (C), the voltage-dependent resistive layer having a second electrode precursor layer formed on a lower surface of the the voltage-dependent resistive layer is disposed in the recessed portion of the green sheet.
The sixteenth aspect: The method according to any one of the eleventh to fourteenth aspect, wherein, instead of the steps (B) and (C), another step is performed wherein the voltage-dependent resistive layer is pressed into the green sheet via the second electrode precursor layer, and thereby forming a recessed portion in the green sheet while disposing the voltage-dependent resistive layer and the second electrode precursor layer in the recessed portion. In this aspect, the voltage-dependent resistive layer located above the second electrode precursor layer is pressed into the green sheet, and thereby the voltage-dependent resistive layer and the second electrode precursor layer are embedded into the green sheet.
The seventeenth aspect: The method according to any one of the eleventh to fourteenth aspect, wherein, instead of the steps (A) to (C), another step is performed wherein the voltage-dependent resistive layer having a second electrode precursor layer formed thereon is pressed into a green sheet under such a condition that the second electrode precursor layer is positioned beneath the voltage-dependent resistive layer, and thereby forming a recessed portion in the green sheet while disposing the voltage-dependent resistive layer and the second electrode precursor layer in the recessed portion. In this aspect, the voltage-dependent resistive layer provided with the second electrode precursor layer therebeneath is pressed into the green sheet from above, and thereby the voltage-dependent resistive layer and the second electrode precursor layer are embedded into the green sheet.
The eighteenth aspect: The method according to any one of the eleventh to fourteenth aspect, wherein, instead of the steps (A) to (C), another step is performed wherein the voltage-dependent resistive layer accommodating the second electrode in an interior thereof is disposed on a main surfaces of a green sheet, and then the voltage-dependent resistive layer is pressed into the green sheet from above by means of a convex-shaped die, and thereby forming a recessed portion in the green sheet with the voltage-dependent resistive layer accommodating the second electrode in the interior thereof disposed in a bottom surface of the recessed portion. In the step (D), the green sheet with the voltage-dependent resistive layer accommodating the second electrode in the interior thereof disposed in the bottom surface of the recessed portion is sintered to produce the substrate with the voltage-dependent resistive layer and the second electrode embedded therein.

While some embodiments of the present invention have been hereinbefore described, they are merely the typical embodiments. It will be readily appreciated by those skilled in the art that the present invention is not limited to the above embodiments, and that various modifications are possible without departing from the scope of the present invention.

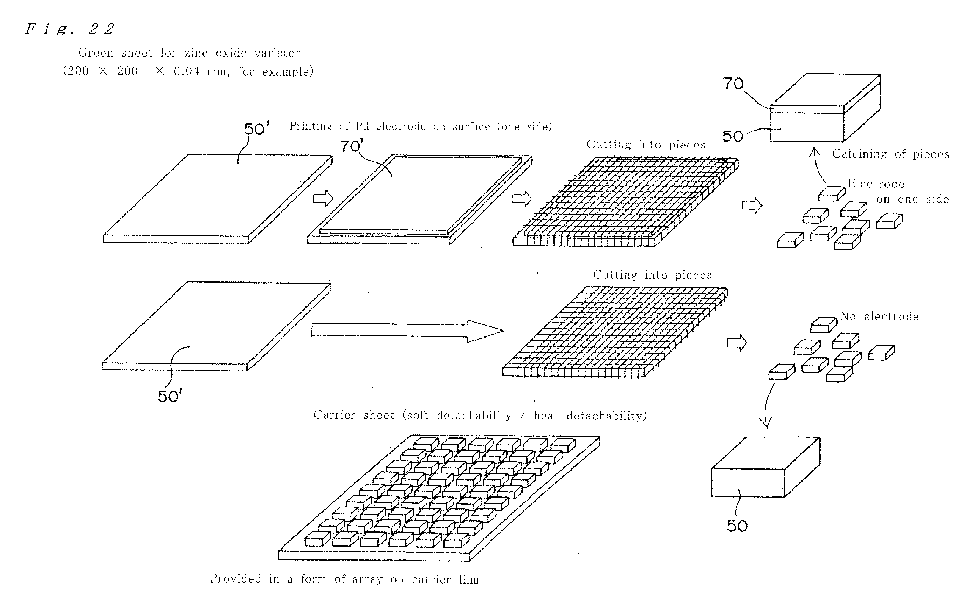

The embodiment of the present invention has been hereinbefore described wherein the voltage-dependent resistive layer disposed in the carrier film is in a form of singular layer. The present invention, however, is not limited to that. For example, an embodiment as illustrated in Fig. 22 may be possible. More detailed explanation about this is as follows: a plurality of green sheets for varistor (especially "green sheets for zinc oxide varistor") are stacked on each other to form the stacked body with the desired thickness. The stacked body composed of the green sheets is cut into small pieces (for example, a razor-like cutter is pressed against the stacked body to cut it into pieces to obtain the desired number of the pieces which are to be arranged on the carrier film). Then, for example, about 100000 pieces of the divided green sheet body are sintered in a batch. Subsequently, the sintered pieces are disposed on the carrier film in a form of array. Alternatively, another process may be possible wherein an printing of an electrode precursor is performed after the formation of the stacked body, followed by the cutting and the sintering thereof. Still another process may also be possible wherein the pieces of the divided green sheet body with no printing of the electrode precursor are sintered, and thereafter the sintered pieces are disposed in a form of array, followed by the printing of the electrode precursor and the heating treatment thereof.

The embodiment of the present invention has been hereinbefore described wherein the voltage-dependent resistive layer, which is in an embedded state within the substrate, is positioned beneath the light-emitting element to be mounted. The present invention, however, is not limited to that. For example, the voltage-dependent resistive layer may be in an embedded state such that at least the part of the layer is in an overlapping relation with the mounting region for the light-emitting element. In this case, the thermal via can be provided immediately below the light-emitting element generating the heat, which leads to an improved heat-releasing performance of the substrate.

The embodiment of the present invention has been hereinbefore described wherein the substrate may have the two-layered structure composed of an upper layer and a lower layer with respect to the case of the heterogeneous ceramic substrate. The present invention, however, is not limited to that. Specifically, the substrate of the present invention may be composed of more than two layers of different materials. For example, the substrate may be three-layered structure or four-layered structure, which also leads to an improved heat-releasing performance of the substrate.

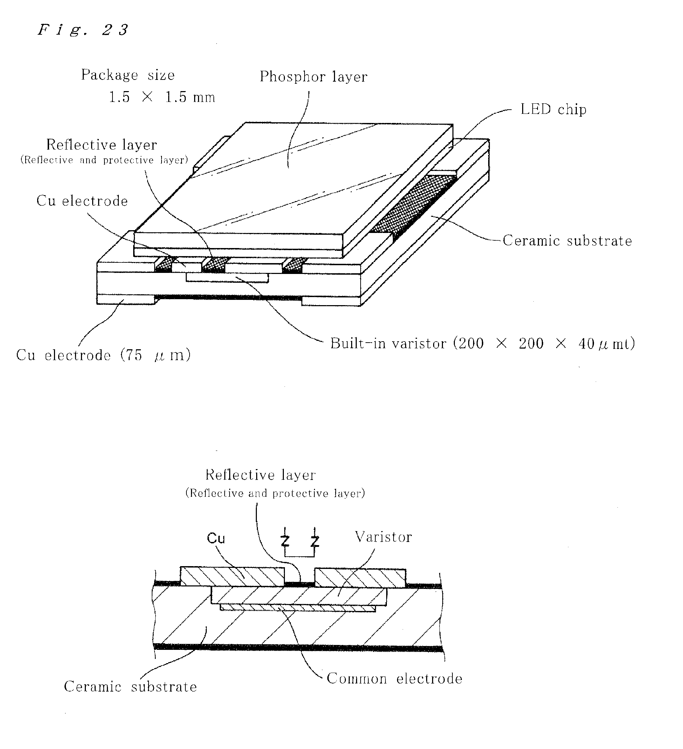

Finally, by exemplifying the LED package as illustrated in Fig. 23, the characteristic of the present invention according to the LED package of Fig. 24 will be described below:
- The complex configuration of the laminated type zinc oxide varistor is no longer required and a down-sizing and a cost reduction can be achieved since the connecting portions and the via holes can be omitted.
- Since the sintered zinc oxide varistor can be used, and thereby a high performance of the varistor can be still hold.
- Copper electrode is used not only for the electrode terminals of the LED, but also for the surface electrode of a zinc oxide varistor as it is. This leads to a relatively simple structure of the package with an improved heat-releasing performance.
- The electrodes can be substantially shared for the use of the zinc oxide varistor and for the use of the LED package.
- The zinc oxide varistor can be provided on either one of the top surface side and the undersurface side of the package substrate.
- The light reflection efficiency can be additionally improved since the reflective layer (especially "reflective layer next to the first electrode") is located beneath the light-emitting element such that they are adjacent to each other.
- The reflective layer can be used for protecting the voltage-dependent resistive layer from its damage occurred during the formation of the electrode of the protection element.

### INDUSTRIAL APPLICABILITY

The LED equipped the substrate for light-emitting element according to the present invention can be suitably available for various lighting uses since it has an improved brightness and a compacted size. Such LED according to the present invention can also be suitably available for wide range of applications, for example, a backlight source application (for LCD images), camera flash application, vehicle installation application.

### CROSS REFERENCE TO RELATED PATENT APPLICATION

The present application claims the right of priority of Japan patent application No. 2012-030741 (filing date: February 15, 2012, title of the invention:

### LIGHT-EMITTING DEVICE AND METHOD FOR MANUFACTURING THE

SAME), the whole contents of which are incorporated herein by reference.

### EXPLANATION OF REFERENCE NUMERALS

- 10: Substrate (or body of substrate)
- 10A: Upper layer of substrate body
- 10B: Lower layer of substrate body
- 10': Green sheet
- 20: Light-emitting element (e.g., LED chip)
- 30: Sealing resin
- 25: Mounting area for light-emitting element
- 42: Convex-shaped die
- 47: Carrier film
- 50: Voltage-dependent resistive layer
- 50': Green sheet for voltage-dependent resistive layer
- 55: Reflective layer (Reflective and protective layer)
- 60: First electrode
- 60a, 60b: sub-electrode of first electrode
- 70: Second electrode
- 70': Second electrode precursor layer
- 70a, 70b: Sub-electrode of second electrode
- 70A₁, 70A₂: Second electrode accommodated in interior of voltage-dependent resistive layer
- 71A₁, 71A₂: External electrode
- 80: Phosphor layer (Fluorescent layer)
- 90: Metal layer (Patterned wiring layer)
- 90': Metal layer
- 95: Via or via hole
- 97: Through-hole
- 98: Bump
- 100: Substrate for light-emitting element according to the present invention
- 110: Protection element
- 150: LED package
- 200: LED package of prior art (Prior art)
- 210: Substrate of package
- 220: LED element
- 270: Zener diode element

## Claims

1. A light-emitting device comprising a light-emitting element and a substrate for light-emitting element,
wherein the light-emitting element is in a mounted state on a mounting surface of the substrate, the mounting surface being one of two opposed main surfaces of the substrate,
wherein the substrate is provided with a protection element for the light-emitting element, the protection element comprising a voltage-dependent resistive layer embedded in the substrate, and comprising a first electrode and a second electrode each of which is in connection with the voltage-dependent resistive layer,
wherein the mounted light-emitting element is in an overlapping relation with the voltage-dependent resistive layer, and
wherein a reflective layer is provided on at least one of the substrate and the voltage-dependent resistive layer such that the reflective layer is located adjacent to the first electrode which is in contact with a substrate exposure surface of the voltage-dependent resistive layer.

2. The light-emitting device according to claim 1, wherein the reflective layer is an insulating layer comprising a resin component and an oxide ceramic component, or an insulating layer comprising a glass component and an oxide ceramic component.

3. The light-emitting device according to claim 1, wherein the reflective layer serves as a protective layer for protecting the voltage-dependent resistive layer.

4. The light-emitting device according to claim 1, wherein the first electrode has a divided form wherein the divided two pieces of the first electrode are positioned on the substrate exposure surface of the voltage-dependent resistive layer, and
wherein the reflective layer, which is located between the divided two pieces of the first electrode, has a narrowed width dimension of 20 µm to 100 µm.

5. The light-emitting device according to claim 1, wherein the reflective layer has a layer thickness of 1 µm to 20 µm.

6. The light-emitting device according to claim 1, wherein the second electrode is positioned in an opposed relation to the first electrode such that the second electrode is in contact with a substrate embedment surface of the voltage-dependent resistive layer or is accommodated within the voltage-dependent resistive layer.

7. The light-emitting device according to claim 1, wherein a surface of the voltage-dependent resistive layer is in the same plane as the one of the two opposed main surfaces of the substrate, and thereby the surface of the voltage-dependent resistive layer forms a part of the mounting surface.

8. The light-emitting device according to claim 1, wherein the protection element is a varistor element.

9. The light-emitting device according to claim 8, wherein the second electrode is positioned in an opposed relation to the first electrode such that the second electrode is in contact with a substrate embedment surface of the voltage-dependent resistive layer; and
wherein the varistor element is composed of serially-connected two varistor elements which share the second electrode provided on the substrate embedment surface of the voltage-dependent resistive layer.

10. A method for manufacturing a light-emitting device comprising a substrate for light-emitting element and a light-emitting element mounted on the substrate, the substrate including a varistor element comprising a voltage-dependent resistive layer embedded in the substrate and first and second electrodes each of which is in connection with the voltage-dependent resistive layer, the method comprising the steps of:
(A) forming a second electrode precursor layer on a main surface of a green sheet;
(B) pressing the second electrode precursor layer into the green sheet from above by means of a convex-shaped die, and thereby forming a recessed portion in the green sheet with the second electrode precursor layer disposed on a bottom surface of the recessed portion;
(C) disposing the voltage-dependent resistive layer in the recessed portion;
(D) sintering the green sheet with the voltage-dependent resistive layer and the second electrode precursor layer disposed in the recessed portion of the green sheet, and thereby producing a substrate with the voltage-dependent resistive layer and the second electrode embedded in the substrate;
(E) forming a reflective layer on the substrate and/or the voltage-dependent resistive layer; and
(F) forming the first electrode on the substrate except for a forming region for the reflective layer, the first electrode being in contact with the voltage-dependent resistive layer.

11. The method according to claim 10, wherein the reflective layer is used for a protection of the voltage-dependent resistive layer from the outside during the formation of the first electrode in the step (F).

12. The method according to claim 10, wherein the formation of the first electrode in the step (F) is performed by a plating processing in which the reflective layer is used for the protection of the voltage-dependent resistive layer from a reagent used for the formation of the first electrode.

13. The method according to claim 10, wherein, in the step (F), the first electrode is formed to be in contact with a substrate exposure surface of the voltage-dependent resistive layer, and
wherein, in the step (E), the reflective layer is formed at a region adjacent to a forming region for the first electrode.

14. The method according to claim 10, wherein, instead of the steps (A) and (B), another step is performed wherein a recessed portion is formed in a main surface of a green sheet by means of a convex-shaped die by pushing the die into the green sheet; and
wherein, in the step (C), the voltage-dependent resistive layer having a second electrode precursor layer formed on a lower surface of the the voltage-dependent resistive layer is disposed in the recessed portion of the green sheet.

15. The method according to claim 10, wherein, instead of the steps (B) and (C), another step is performed wherein the voltage-dependent resistive layer is pressed into the green sheet via the second electrode precursor layer, and thereby forming a recessed portion in the green sheet while disposing the voltage-dependent resistive layer and the second electrode precursor layer in the recessed portion.

16. The method according to claim 10, wherein, instead of the steps (A) to (C), another step is performed wherein the voltage-dependent resistive layer having a second electrode precursor layer formed thereon is pressed into a green sheet under such a condition that the second electrode precursor layer is positioned beneath the voltage-dependent resistive layer, and thereby forming a recessed portion in the green sheet while disposing the voltage-dependent resistive layer and the second electrode precursor layer in the recessed portion.

17. The method according to claim 10, wherein, instead of the steps (A) to (C), another step is performed wherein the voltage-dependent resistive layer accommodating the second electrode in an interior thereof is disposed on a main surfaces of a green sheet, and then the voltage-dependent resistive layer is pressed into the green sheet from above by means of a convex-shaped die, and thereby forming a recessed portion in the green sheet with the voltage-dependent resistive layer accommodating the second electrode in the interior thereof disposed in a bottom surface of the recessed portion; and
wherein, in the step (D), the green sheet is sintered to produce the substrate with the voltage-dependent resistive layer and the second electrode embedded therein.
